# EUROPEAN PATENT SPECIFICATION

(11) **EP 2 761 642 B1**
(45) Date of publication and mention of the grant of the patent: **23.08.2017**
(21) Application number: 12770084.7
(22) Date of filing: 27.09.2012
(51) Int. Cl.: H01J 37/08, H01J 37/317, H01J 27/02, C23C 14/32, C23C 16/452

(54) **ION BEAM GENERATOR AND METHOD OF MANUFACTURING A COMPOSITION USING SAID GENERATOR**
IONENSTRAHLERZEUGER UND VERFAHREN ZUR HERSTELLUNG EINER ZUSAMMENSETZUNG MIT DIESEM ERZEUGER
DISPOSITIF DE GÉNÉRATION DE FAISCEAU IONIQUE ET PROCÉDÉ DE PRODUCTION D'UNE COMPOSITION AVEC UN TEL DISPOSITIF

(30) Priority: 29.09.2011 US 201161540558 P
(43) Date of publication of application: 06.08.2014
(60) Divisional application: 15175725.9
(73) Proprietor: Nitride Solutions Inc., Wichita, Kansas 67213 (US)
(72) Inventor: BRORS, Daniel, Discovery Bay, CA 94505 (US); DEMARAY, Richard Ernest, Portola Valley, CA 94028 (US); SLUTZ, David, Bethlehem, PA 18015 (US)
(74) Representative: Bumke, Jakob Wenzel
(86) International application number: PCT/EP2012/069156
(87) International publication number: WO 2013/045596

(56) References cited:
- WO-A1-2010/069594
- DE-A1- 10 111 515
- DE-C1- 19 841 012
- US-A- 5 227 203
- US-A- 5 317 006
- US-A- 5 846 608
- BARDOS L: "Radio Frequency Hollow Cathodes for The Plasma Processing Technology", SURFACE AND COATINGS TECHNOLOGY, ELSEVIER, AMSTERDAM, NL, vol. 86-87, 1 December 1996 (1996-12-01), pages 648-656, XP003003296, ISSN: 0257-8972, DOI: 10.1016/S0257-8972(96)03056-3

## Description

This invention relates to inorganic materials, methods and apparatus for making same, and uses thereof; and is particularly, although not exclusively, applicable to making ceramic materials such as III-V semiconductors.

In the following, reference is made to making III-V semiconductors, in particular, but not exclusively, nitrides, but it will be clear to the person skilled in the art that the methods and apparatus disclosed may be used for the production of other materials, and as an example, manufacture of diamond is exemplified.

### Background

### III-V semiconductors

III-V semiconductors are materials based on binary III-V compounds in which a Group III element is matched with a Group V element.

While GaAs has been known for a long time, current interest is in the nitride III-V compounds GaN, InN, and AlN and ternary and quaternary nitrides of Ga, Al, and In. Binary alloys (ternary compounds) such as that between AlN and GaN or InN and GaN are conventionally known respectively as AlGaN and InGaN. These conventional names AlGaN and InGaN are not chemically correct formulae and in the following the term (Al,Ga,In)N is used.

**"(Al,Ga,In)N"** is meant to be broadly construed as meaning the nitrides of Al, Ga, and In (AlN, GaN, InN), as well as alloys thereof, and encompasses materials of composition (Alᵢ,GaⱼInₖ)N (where i+j+k =1) together with non-stoichiometric compositions (where i+j+k ≠1) and doped compositions.

GaN, AlN and InN come in both hexagonal (wurtzite) and cubic (zinc blende) crystal structures. The hexagonal form is the stable form at room temperature and pressure, although the cubic form may be made by epitaxial growth of thin films on suitable substrates. Both hexagonal and cubic GaN and AlN are known as substrates for semiconductor devices. The wurtzitic polytypes of GaN, AlN and InN form a continuous alloy system with band gaps ranging from 0.78eV for InN, through 3.42eV for GaN to 6.2eV for AlN thus potentially permitting the manufacture of optical devices active at wavelengths ranging from the red into the ultraviolet.

III-V semiconductors or doped III-V semiconductors have been proposed for or are in use for many applications, including:-
**Electronic devices,** for example and not limited to: high electron mobility transistors (HEMT) also known as heterostructure FET (HFET) or modulation-doped FET (MODFET); metal semiconductor field effect transistors (MESFET); bipolar (junction) transistors (BJT); heterojunction bipolar transistors (HBT); Schottky diodes; thyristors; rectifiers; RF/microwave transmitters; high voltage power electronics; gas sensors; actuators;
**Opto-electronic devices,** for example and not limited to: light emitting diodes (LED); laser diodes (LD); deep ultraviolet light sources (http://en.wikipedia.org/wiki/Deep_ultraviolet); photodetectors; dielectrics in optical storage media;
**Piezoelectric devices,** for example high temperature piezo electric devices that can operate in excess of 400 °C.
**Electro-acoustic devices,** for example and not limited to: surface acoustic wave (SAW) devices (http://en.wikipedia.org/wiki/Surface_acoustic_wave);
**MEMS devices ,** for example and not limited to: thin film bulk acoustic resonators (FBAR or TFBAR) (http://en.wikipedia.org/wiki/Thin_film_bulk_acoustic_resonator);
**Spintronic devices** (http://en.wikipedia.org/wiki/Spintronics)
**Device substrates and packaging,** particularly where the high thermal conductivity is of importance.

Reviews of applications and current manufacturing technologies can be found in a variety of places, including: Handbook of Nitride Semiconductors and Devices, ed. Hadis Morkoç, 2008, Wiley-VCH, ISBN 978-23-527-40837-5; Substrates for GaN-Based Devices: Performance Comparisons and Market Assessment, Strategies Unlimited report SC-27, 2006 and follow up report SC-29, 2009.

Materials for use as substrates in semiconductor applications require high purities and low defect levels. Defects can come in many sorts, and a common source of defect for material grown on a substrate is lattice mismatch.

Light emitting diodes may contain layers of GaN and alloys thereof with InN and AlN (commonly referred to as InGaN and AlGaN) grown on a substrate. Commonly used substrates include but are not limited to silicon, sapphire (Al₂O₃); silicon carbide; gallium nitride; and aluminium nitride. Sapphire and silicon have the advantage of being inexpensive (sapphire about twice as expensive as silicon), but have a large lattice mismatch with GaN. Lattice mismatch is important because it leads to strain and defects in material grown on the substrate. To overcome the strain it is common for interlayers to be used to provide for a progressive change but this adds manufacturing complexity and cost.

Single-crystal silicon carbide has a better lattice match to GaN, and has a high thermal conductivity which is useful for high power applications, but materials suitable for use as semiconductor substrates cost more than 10 times the cost of sapphire substrates. What industry is seeking is good quality GaN and AlN for use as substrates. Although substrates are available the quality is variable and the cost very high (of the order of 10 or more times the cost of silicon carbide substrates).

GaN is the preferred material to manufacture blue LED and laser diodes because of the high band gap. AlN is the preferred material for the manufacture of ultraviolet laser diodes. AlN is also a preferred material for very high power high frequency devices because of its high thermal conductivity and low dielectric constant.

### Manufacturing methods

Over time, various methods have been proposed for the manufacture of III-V semiconductors.

### Chemical reaction methods

Bulk aluminium nitride powders are generally made by methods such as carbothermal reduction of alumina under a nitrogen atmosphere [e.g. US4618592]. However this produces powders that require sintering aids to produce dense bodies, and have too many impurities to permit use as substrates for semiconductors.

Directly nitriding aluminium powder has been proposed as a means to produce AlN for subsequent sintering.

JP63095103 [according to an English abstract (from espacenet)] relates to a process in which aluminium metal powder and NH₃/H₂ are passed through an N₂/Ar plasma and the resulting powder collected downstream.

JP63095103 [according to an English abstract(from espacenet)] relates to a similar process in which gas containing N₂/NH₃/H₂ and inert gas is excited to form a plasma, a tail part of which impinges on metallic Al to melt and evaporate it, and thereby form ultrafine AlN particles.

### Physical vapour deposition

Physical vapour deposition (PVD) is a process in which vapour is produced by physical means and coats a substrate impinged upon the vapour. The vapour is generally produced by either an evaporative process [through heating] or by sputtering. Gas may be introduced to react with the vapour at the substrate surface in a process known as reactive deposition. Sometimes electron beams may be used to bombard the depositing surface and assist with deposition.

US4997673 relates to a physical vapour deposition method [reactive evaporation] of forming aluminium nitride films by placing a substrate in a vacuum, and subjecting the substrate to aluminium and to nitrogen ion irradiation. The aluminium was evaporated using electron beam heating of the aluminium, with the electron beam being provided from an electron gun housed within the vacuum chamber. The pressure in the chamber was 10⁻⁵ to 10⁻⁷ Torr [1.33mPa to 13.3µPa].

US7494546 relates to a reactive evaporation process for production of nitride thin films and coatings in a system operating at 10⁻¹ to 10⁻⁸ Torr [13.3Pa to 1.33 µPa] with best growth rates for GaN at 10⁻⁴ Torr [13.3mPa] of only 3-4 Å.s⁻¹ [1.08 - 1.44 µm/hour].

Reactive evaporation processes have not been demonstrated with deposition rates above ∼10µm/hour and so have been used for the production of films rather than manufacture of bulk materials. Low deposition rates not only have the drawback of speed and energy cost of manufacture, they also risk entrapment of impurities in the growing material.

US5534314 discusses drawbacks of normal PVD processes [high vacuum requirement and low deposition rates] and relates to a process for vapour depositing an evaporant onto a substrate comprising: presenting the substrate to a deposition chamber, wherein said deposition chamber has an operating pressure of from 0.001 Torr [133mPa] to atmospheric pressure and has coupled thereto a means for providing a carrier gas stream and a means for providing an electron beam at the operating pressure and further contains an evaporant source; impinging the evaporant source with the electron beam to generate the evaporant; entraining the evaporant in the carrier gas stream; and coating the substrate with the carrier gas stream which contains the entrained evaporant.

US5534314 alleges deposition rates of >100µm/minute in contrast to the ∼10 µm/hour to be expected of PVD processes, and nitrides are stated to be materials that can be evaporated using the electron beam. However, US5534314 does not envisage reaction of the evaporant with the carrier gas stream and is not a reactive evaporation process. This process is not known by the applicants to be in use for the production of III-V semiconductors.

Sputtering is generally thought to provide higher deposition rates than evaporative PVD. In sputtering, a target is bombarded with ions, generally from a plasma, and atoms from the target travel to a substrate.

DE10111515A1 relates to a plasma coating device comprising a hollow cathode containing a glow discharge; a vacuum chamber containing a substrate to be coated and the cathode; and a container for receiving vapor-like coating material. The cathode is structured so that the coating material can be transported from inside of the cathode to the substrate.

US6692568 and related US6784085 (among others) disclose a method alleged to produce single crystal M^{III}N by a sputtering process in which an Ar/N₂ mixture is used in combination with a magnetron arrangement and hollow cathode plasma injectors to form a plasma over a target, and atoms sputtered from the target are used to reactively coat a substrate. In this arrangement the target and plasma injectors function as cathodes and the substrate as an anode. In one of the embodiments of this process an annular containment shield and magnet are provided to focus sputtered material onto a substrate.

A major problem associated with using the sputtering process for reactive deposition is the difficulty of controlling the proportion of reactants. For example, when producing AlN the ratio of N₂ in the Ar would need to be carefully controlled. Too little N₂ in the gas mixture means that the proportion of Al atoms reaching the substrate would be too high, and so the deposited material would be a mixture of AlN and Al metal. Too much N₂ causes the Al target to become coated with a thin film of AlN causing electrical arcing on the target surface. This electrical arcing can cause the target surface to explode in tiny droplets of Al which cannot fully react with ionized nitrogen, again forming a mixture of AlN and Al metal. US6692568 discloses insertion of gas and generation of plasma for sputtering close to the sputtering target.

As a result of their defects, neither evaporative nor sputtering PVD processes are known by the inventors to be currently in commercial use for the manufacture of bulk III-V semiconductors for microelectronics; although PVD processes such as molecular beam epitaxy (MBE) and others are used for the production of nitride films and layers on substrates.

WO2009/066286 is directed to producing amorphous III-V materials attached to a substrate by a reactive evaporation method.

Current commercial methods for making bulk high purity III-V semiconductor substrates appear to concentrate on other techniques, for example.

### Chemical vapour deposition

Chemical vapour deposition is a process in which vapour phase reactants combine to produce a deposit on a substrate.

A method used commercially is known as hydride vapour phase epitaxy in which carrier gases dissociate to form the deposit and fugitive gases such as hydrogen chloride. Typically, ammonia is used as a carrier for nitrogen, and chloride species as carriers for Group III elements, although organo metallic materials may be used.

Such chemical processes are liable to result in contamination [e.g. oxygen, halide and carbon] from the compound material sources or from the containment vessels used in the process. Oxygen is a particularly prevalent contaminant and typical purity levels for these materials are "3 nines" (99.9%) pure [ignoring any oxygen] with oxygen contamination at 1-5 percent.

Oxygen contamination greatly reduces the thermal conductivity of AlN, and introduces defects into the material.

US7655197 relates to "microelectronic device quality" (Al,Ga,In)N single crystal articles claimed to have a top surface defect density of less than 10⁷ defects cm⁻² and allegedly defect densities of less than 10⁴.cm⁻² are achievable by the method disclosed [although no examples showing such defect levels are disclosed]. These articles were made by a high growth rate vapour phase epitaxy [VPE] method using group III precursors such as halides, hydrides, and metalorganics.

Related US6596079 relates to manufacture of (Al,Ga,In)N boules made by growing on an (Al,Ga,In)N seed crystal by vapour phase epitaxy.

US7576372 relates to free-standing hexagonal AlGaN wafers made by a VPE method.

US7075111 relates to nitride semiconductor substrates made by hydride vapour phase epitaxy (HVPE).

US6616757 relates to a method of making GaN single crystal boules by a VPE method. Related US6936357 relates to an AlGaN crystal made in similar manner.

US2006/280668 relates to a freestanding AlN single crystal, wherein the freestanding AlN single crystal is crack-free, at least 5 millimetres thick, at least 2 inches in diameter, and has a defect density of less than 10⁷ cm⁻². A hydride vapour phase epitaxy method is mentioned.

US2009/0092815 relates to a freestanding AlN single crystal wafer that is crack-free, has a thickness of at least 100 µm, a diameter of at least 2 inches (∼5cm) and a thermal conductivity greater than 3.2 W/K cm. A hydride vapour phase epitaxy method is mentioned.

### Physical vapour transport

Physical vapour transport (PVT) in which a source of material [e.g. AlN] is held at a hotter part of a thermal gradient to sublime the source material which then condenses to form single crystals in a cooler part of the gradient. The condensation can be either seedless condensation, or on a seed of the material being made.

US2007/0169689 relates to aluminium nitride crystals having defect densities of 10⁴.cm⁻² or less, but made through a high temperature vapour phase method that would involve significant oxygen contamination [at least 0.1%].

US6296956 relates to single crystal AlN having impurity levels below 450ppm and produced by a high temperature vapour phase method.

US2007/0101932 relates to aluminium nitride crystals having defect densities of 10⁴.cm⁻² or less, again made by a high temperature vapour phase method.

WO2007/062250 relates to aluminium nitride crystals having dislocation densities of 10⁴.cm⁻² through a high temperature vapour phase method involving Al and N₂ vapour in which efforts are made to keep the oxygen and hydrogen concentration low [less than 300ppm and 0.5% respectively] as these gases have been shown to create microvoids in the AlN material.

### Other processes

GaN crystals are commercially available from companies such as TopGaN made by a process in which Ga or GaN powder is used as a source of gallium to react with N₂ or nitrogen derived from NH₃ at elevated temperatures and pressures (believed to be in the range of about 75,000 psi to 900,000 psi at temperatures believed to be in the range 600°C to 2400°C).

US7642122 relates to a method of making nitride crystals in a supercritical fluid at temperatures higher than about 550°C and pressures higher than about 2kbar.

Various companies adopt an "ammonothermal" process for growing hexagonal GaN on seeds. In this process Ga or GaN in one part of a sealed apparatus provides a feedstock which is dissolved in ammonia and is driven by a temperature gradient to another part of the apparatus where it crystallises on seeds. Typical conditions are 500°C - 700°C at 0.1-0.5GPa.

Ammonothermal processes are also used for the production of AlN.

GaN has also been made by the sodium flux method, which involves the growth of GaN in gallium-sodium melts exposed to nitrogen gas under pressure.

GaN has also been grown by transporting Ga vapour from decomposing GaN powder to the seed under an NH₃ atmosphere at about 1155°C.

Other patents that discuss semiconductor substrates made from III-V semiconductors include EP1743961, US5993699, US5954874, US5858086, US5972109 and US6066205.

New methods of making (Al,Ga,In)N materials with low contaminant [e.g. oxygen] content and/or low defect densities would be useful.

Additionally, for high pressure methods, new presses are required. High pressure high temperature (HPHT) machines have been used for a number of years to manufacture synthetic diamonds. The first successful machine was invented by H.T. Hall in 1958, [US2947610], and became known as a belt press. The belt press (and variations of it) has been in use ever since to manufacture synthetic diamonds. A second type of press was also invented by Dr. Hall. Termed a tetrahedral anvil press, this was patented as US2918699 in 1959. It was the basis for the cubic press, which may be the most widely used type of HPHT press used in diamond synthesis today. Variations of this have also been patented, with the first cubic press patented as US3440687 in 1969. Although cubic presses have smaller process chambers than belt presses, the operating costs are much lower than for belt presses. Further patents for the cubic press include US5744170.

In addition to the use of such presses in synthesis of synthetic diamonds, more recently presses have been used in clarification of natural diamonds and in the manufacture of low-defect single crystal gallium nitride. Both of these processes require much higher temperatures and longer times than are required for diamond synthesis. Diamond synthesis typically requires temperatures of about 1500°C for times of about 40 minutes when using an iron-nickel catalyst, although the temperature required is strongly dependent on the catalyst chosen and can be below 1300°C.

In order to clarify diamonds and synthesize single crystal gallium nitride and aluminium nitride, temperatures far in excess of 1500 °C are required and this requires additional process insulation between the hot process chamber and the cemented tungsten carbide press components, more than is usual in either belt or cubic press and special designs of each are required to maintain tungsten carbide below 600°C, which is important since above this temperature the tungsten carbide strength rapidly deteriorates.

The present application also discloses a press design which is capable of achieving high temperatures and pressures and can be used in a low cost HPHT process for diamond synthesis. It is also capable of achieving the more extreme conditions required for diamond clarification and synthesis of single crystal gallium nitride and aluminium nitride and for other HPHT work.

### SUMMARY OF INVENTION

A first aspect of the present invention provides an ion beam generator comprising:
a) a first chamber housing one or more vapour generators capable of forming a vapour from one or more condensed phase sources of material;
b) a second chamber adjacent the first chamber housing one or more plasma generators comprising
   one or more cathodes having one or more open-ended channels extending therethrough, the channels comprising one or more channel walls and having a length extending from one end of the channel to another end of the channel to define one or more spaces
   and capable of forming plasma within said one or more spaces;
c) one or more apertures between the first and second chambers arranged to permit vapour generated in the first chamber to enter the second chamber
   the one or more vapour generators and one or more plasma generators being arranged whereby in operation, vapour generated by the one or more vapour generators may traverse the one or more spaces through plasma formed by the one or more plasma generators. The ion beam generator is operable to provide a lower pressure in the first chamber than in the second chamber.

The vapour generator may comprise at least one electron beam generator, operable to direct an electron beam at the one or more condensed phase sources of material.

The at least one electron beam generator may be operable to magnetically bend electrons from the electron beam generator to the one or more condensed phase sources of material.

The plasma generator may further comprise one or more housings spaced from and electrically insulated from the one or more cathodes.

The plasma generator may further comprise a source for a magnetic field configured to lie substantially parallel to the one or more channel walls for a substantial fraction of the length of the channel.

The source for a magnetic field may comprise at least one first magnet situated proximal the vapour generator, and at least one second magnet situated distal the vapour generator.

The source for a magnetic field may comprise an electromagnet.

Magnetic shielding may be disposed between the vapour generator and the plasma generator. A second aspect of the present invention relates to apparatus for manufacturing a material by vapour deposition, the apparatus comprising:-
a) at least one ion beam generator according to the first aspect;
b) at least one gas supply operable to supply gas for conversion into plasma within the at least one ion beam generator;
c) at least one substrate mount to receive at least one substrate, and positioned to permit in use at least one substrate mounted to the at least one substrate mount to be bombarded by ions from the at least one ion beam generator.

The apparatus may further comprise a source operable to apply a bias to a substrate mounted in the substrate mount.

The source may be operable to apply a radio frequency to a substrate mounted in the substrate mount.

A heater may be provided to heat the substrate mount.

One or more vents may be situated between the plasma chamber and the substrate mount, and operable to admit gas close to the substrate mount.

The vapour generator may be capable of evaporative formation of a vapour from one or more condensed phase sources of material, and comprising a source operable to inject gas in the region of the vapour generator to inhibit reaction between reactant gases and at least a surface of the condensed phase sources of material.

The apparatus may be operable to provide a lower pressure in the first chamber than in the second chamber.

The apparatus may comprise a shutter selectively operable to inhibit transfer of vapour from the first chamber to the second chamber.

One or more crucibles may be provided to house said one or more condensed phase sources of material.

A third aspect of the present invention relates to a method of manufacturing a composition or an article comprising a composition, the method comprising the step of, in an apparatus according to the second aspect, forming an ion beam from the at least one ion beam generator and bombarding at least one substrate with ions from the ion beam to form a deposit on the substrate.

The deposit on the substrate may form an adherent coating to the substrate.

The substrate may be a coated substrate having a surface coating, and the deposit forms on the surface coating.

The substrate may be a crucible body and the deposit on the substrate forms an adherent coating in contact with at least an inner surface of the crucible body.

The deposit may be chemically attached to said substrate.

The surface coating may comprise diamond or diamond-like carbon.

A surface of the substrate may be polished prior to forming the deposit on the surface.

Additional bombardment of the substrate may come from ions produced in the vicinity of the substrate.

The composition may comprise at least a first component and at least a second component, and the ion beam may comprise at least the first component.

The ion beam may further comprise further components of the composition.

The composition may be deposited at a rate in excess of 40µm/hour.

The deposited composition may be deposited to a thickness in excess of 1mm.

The deposited composition may be separated from the substrate to form a freestanding body.

The deposited composition may be divided to form wafers.

The deposited composition may be divided to form substrates.

The substrates may be for use in the method of the third aspect of the invention.

The deposited composition may be used as is, or further processed to form one or more components in a device comprising one or more of: electronic components; opto-electronic components; electro-acoustic components; MEMS components; and/or spintronic components.

Said component may be a heat conductor or heat spreader.

The composition may be an (Al,Ga,In)N composition.

The composition may be crystalline hexagonal AlN.

The substrate may be, or may be coated with, a metal, glass, ceramic, diamond, or diamond-like carbon.

### DESCRIPTION

In the following non-limitative description reference is made to the drawings in which:
Fig. 1 is a schematic diagram of apparatus in accordance with one aspect of the present invention;
Fig.2 is a schematic diagram of a plasma generator usable in the apparatus of Fig. 1;
Fig. 3 is a schematic diagram of a vapour generator usable in the apparatus of Fig. 1;
Fig. 4 is a schematic diagram of the apparatus of Fig. 1 and associated equipment;
Fig. 5 is a cross section of a typical conventional belt press;
Fig. 6 is a cross section of a press as disclosed in the present application;
Fig. 7 is a cross section depicting the major components of the press of Fig. 6;
Fig. 8 is a detailed cross section of a process chamber and thermally insulating layer;
Fig. 9 is a view of an alternative process chamber and thermally insulating layer;
Fig. 10 is a view of a process chamber used for diamond production;
Fig. 11 is a view of a process chamber used for diamond clarification;
Fig. 12 is a view of a process chamber used for single crystal GaN production;
Fig. 13 is a view of a process chamber and associated pressure-transferring parts for use in AlN production;
Fig. 14 is a photograph comparing a tantalum crucible with an AlN coated tantalum crucible;
Fig. 15 is an XRD trace showing AlN produced by the present invention;
Fig. 16 is a TEM photograph of AlN produced in HPHT apparatus;
Fig. 17 is a photograph of a graphite substrate with a 5 µm AlN coating that was heat cycled to 1100°C;
Fig. 18 is a photograph of a 15 µm coating on a diamond coated silicon substrate that was heated to 1100°C
Fig. 19 is a schematic drawing of a laminated product.
Figs. 20 and 21 are schematic drawings exemplifying use of the laminated product of Fig. 18.

### Definitions

In the following:
Relative positional terms such as **"upper" "lower"** and **"beneath"** are meant to indicate the relationships shown in the drawings and do not imply restrictions on the scope of the invention.

**"Condensed phase"** is to be interpreted as indicating solid, liquid or mixtures thereof.

**"Ion beam"** is to be taken as meaning a flow of gaseous/plasma material comprising ions but which may also contain neutral species.

### General description of PVD method and apparatus

The overall concept of the PVD apparatus is to provide:
- one or more vapour generators capable of forming a vapour from one or more condensed phase sources of material;
- one or more plasma generators comprising one or more cathodes having one or more open-ended channels extending therethrough, the channels comprising one or more channel walls and having a length extending from one end of the channel to another end of the channel to define one or more spaces and capable of forming plasma within said one or more spaces;
the one or more vapour generators and one or more plasma generators being arranged whereby in operation, vapour generated by the one or more vapour generators may traverse the one or more spaces through plasma formed by the one or more plasma generators.

Some of the vapour will traverse the plasma as neutral species; and some will be ionized while traversing the plasma adding to the plasma.

After traversing the plasma the vapour may impact a substrate to form a composition thereon.

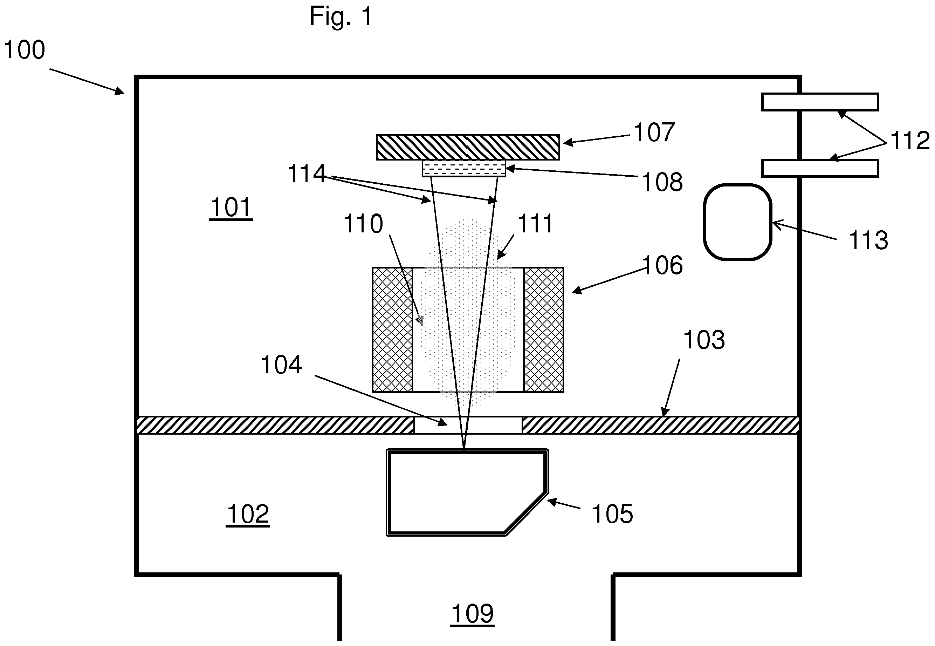

### Example PVD apparatus of Figs. 1 to 4

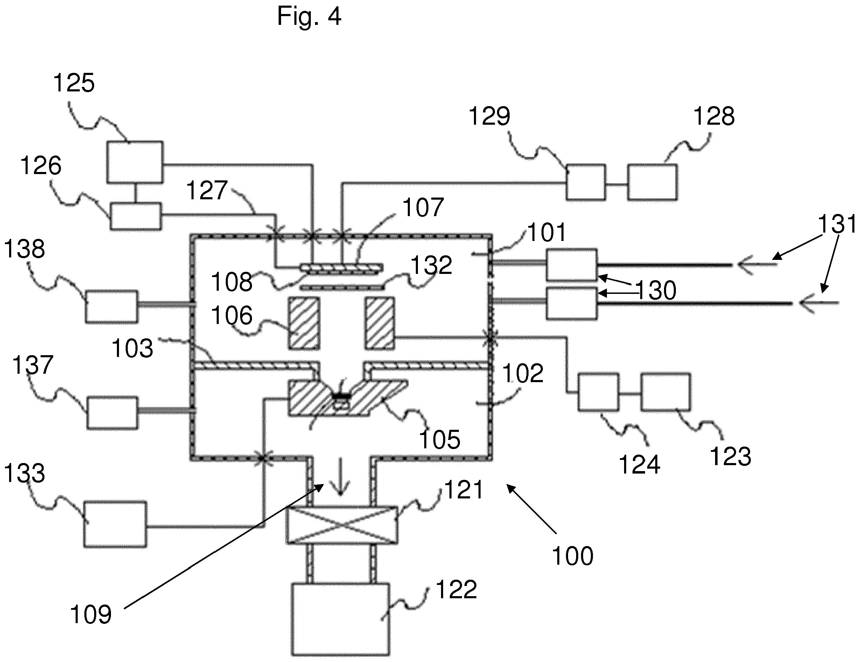

Apparatus 100 is shown in Fig. 1 and with associated equipment in Fig. 4, and consists of an upper chamber 101 and a lower chamber 102 separated by a partition 103 having an aperture 104 communicating between the upper chamber 101 and lower chamber 102. The upper chamber 101 and lower chamber 102 can be separated to permit access to the interior, although alternative means of access [for example doors or ports] can readily be envisaged by the person of ordinary skill in vacuum technology.

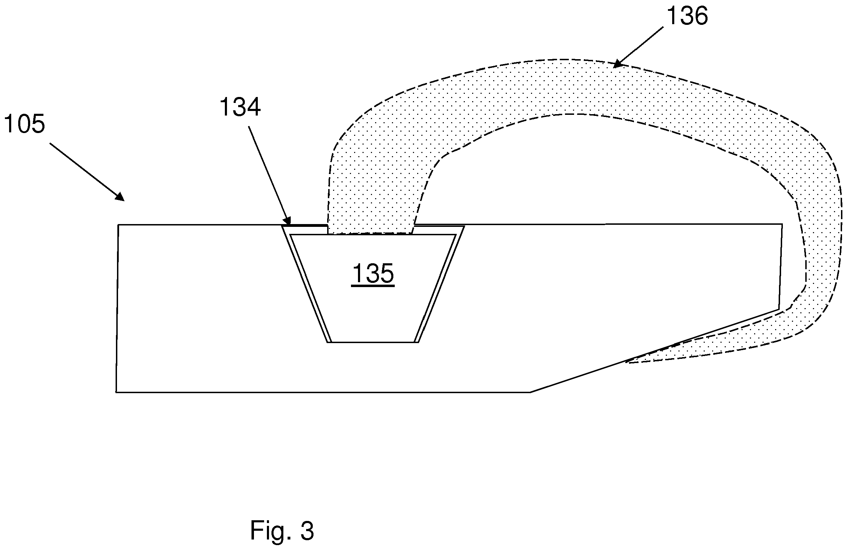

Beneath the aperture 104 is a vapour generator 105 (shown in more detail in Fig. 3).

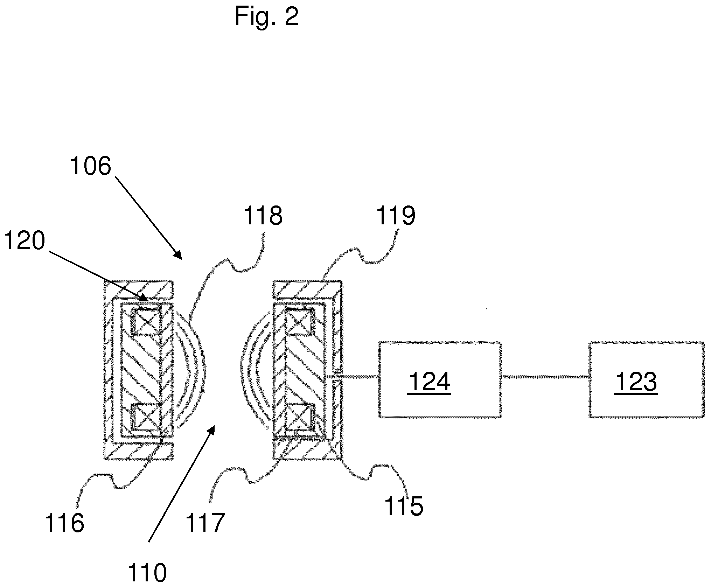

In the upper chamber 101 is a plasma generator 106 (a useful form of plasma generator 106 is shown in more detail in Fig. 2) and a substrate mount 107 to which a substrate 108 may be mounted.

Plasma generator 106 comprises a space 110 within which, in operation, a plasma 111 is generated which may extend outside the confines of the space 110. The plasma generator 106 shown is annular in form, but it can be readily appreciated that other arrangements [e.g. opposed plate cathodes, spiral cathodes - see *Radio frequency hollow cathodes for the plasma processing technology,* I. Bárdo 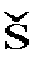 , Surface and Coatings Technology 86-87 (1996) 648-656] can be used to provide a space within which the plasma may be generated.

In WO2009/092097 reference is made to a concentric hollow cathode device in which an annular core of the hollow cathode functions as a sputtering target. The device of WO2009/092097 is not suitable for use in the present invention as it is closed at one end.

The plasma is generated from gas introduced into upper chamber 101 [for example through gas inlets 112]. An optional gas cleaner 113 may be provided within the chamber to reduce the content of oxygen and/or water vapour in the chamber. Dependent upon the gases used, the gas cleaner 113 may include a cold trap and/or an oxygen getter. Examples of cold traps include Meissner traps, in which liquid nitrogen is used to collect oxygen and/or water. [However Meissner traps are generally not useful when ammonia is a nitrogen source]. Examples of oxygen getters include, for example, a magnetron sputter source of a reactive metal which is used to getter oxygen and moisture from the process chamber. Suitable reactive metals include Ti, Zr , Hf, or Y.

The vapour generator 105 and plasma generator 106 are arranged such that when both are operating vapour 114 generated by the vapour generator 105 traverses the plasma 111.

Fig. 2 shows a useful form of plasma generator 106, although the invention is not limited to the specific geometry shown. A water cooled (water cooling is not shown) annular cathode backing 115 houses an annular cathode facing 116 which defines the space 110 within which plasma is generated. As shown, the space 110 is cylindrical in form having a length (from one open end of the channel to the other) and a diameter. The cathode facing 116 can be of any suitable material, but is preferably chosen to have elements in common with the material being made so that any material sputtered from the cathode facing 116 is less likely to contaminate the material being made. For example, when making AlN, it can be useful for the cathode facing to be of aluminium, e.g. 6 nines pure Al.

Two rows of magnets 117 are housed between cathode backing 115 and cathode facing 116. One row of magnets has the north poles facing inward and the other row has the south poles facing inward. The resulting magnetic flux 118 is aligned parallel with the cathode facing 116 for a substantial part of the length of the space 110. A yoke [not shown] may join the ends of the magnets 117 remote from the cathode facing 116 so that the magnets 117 form part of a magnetic circuit with the yoke and the magnetic flux 118 in the space 110. It will be evident that one or more electromagnets may provide the same effect.

Cathode housing 119 is electrically isolated from the cathode backing 115 and cathode facing 116 and acts as an anode with respect to the cathode backing 115 and cathode facing 116, serving to prevent plasma forming on the outside of cathode backing 115. Conveniently cathode housing 119 is separated from cathode backing 115 to form a so-called dark space 120. "Dark space" is a narrow space small in comparison with the mean free path of electrons at the operating pressure, resulting in no plasma discharge between the housing 119 and the cathode 115. The plasma is confined only to the surface of cathode facing 116 so that there is no ionization of the gases: electrons from the cathode reach the cathode housing without exciting a discharge in the dark space. It is possible to dispense with the cathode housing and use the walls of the upper chamber 101 as an anode, but this would result in stray plasma and excessive generation of deposited material where it is not wanted, unless the walls of the chamber can be used for the dark space shield.

Fig. 3 shows a vapour generator 105 usable in the present invention. The vapour generator 105 may comprise an electron beam generator, operable to direct an electron beam at a condensed phase source of material, for example a first component of a composition to be deposited on substrate 108. The vapour generator comprises on its top face a depression 134 to receive an optional crucible 135. An electron gun (not shown) is situated on the underside of the vapour generator and magnets (not shown) are operable to bend an electron beam 136 from the electron gun to impact material held in the crucible 135. Such vapour generators are known, and a suitable apparatus is a Temescal Corporation Model SFIH-270-2.

Fig. 4 shows the apparatus of Fig. 1 with associated equipment. The lower chamber 102 has a conduit 109 connecting via a gate valve 121 to a vacuum pump 122 (for example, an Edwards Model 30). A cryogenic pump may be preferred. To measure pressure in the system, pressure gauges 137 and 138 are connected respectively to the lower and upper chambers 102,101. Pressure gauges 137 and 138 may be of any type suitable for the pressures and gases to be experienced. Typically, for the pressure gauge 137 an ion gauge can be used as pressures of the order of 10⁻⁶ to 10⁻³ Torr (0.133 mPa to 133.3 mPa) are likely to be experienced (the gauge may be controlled, for example, by a Granville Phillips Model 270). For the pressure gauge 138 a baratron (for example MKS Model 125AA) may typically be used as the pressures experienced are likely to be higher than in the lower chamber. The invention is not limited to any particular pressure measurement method.

Such an arrangement in which the pressure in the lower chamber is lower than that in the upper chamber, has the advantage that electron beam sources work best at low pressure and maintaining a low pressure in the lower chamber prevents high voltage arcing from the filament to ground while allowing sufficient gas pressure in the upper chamber 101 to allow the hollow plasma generator to efficiently ionize nitrogen-containing gas.

A shutter can be mounted between the upper and lower chambers for selective operation if it is determined that the metal vapour is coating the surfaces of the hollow cathode with metal prior to the application of gases and plasma generation.

The cathode backing 115 (shown in Fig. 2) of the plasma generator 106 is attached to a voltage supply, which in the embodiment depicted is an RF generator 123 (for example a Dressler Model Cesar) attached through a matching network 124 (for example a Dressler Model Cesar).

Partition 103 may be of steel or like soft magnetic material, and optionally may be connected to cathode housing 119 (shown in Fig. 2), to provide magnetic shielding to inhibit interaction of the magnetic field of the plasma generator with the magnetic field of the vapour generator 105; and more particularly to inhibit interaction of the magnetic field of the plasma generator 106 with the electron beam 136.

The substrate mount 107 is in the form of an electrically resistance heated chuck supplied with power from a power supply 125 (for example a Eurotherm SCR 40) controlled by a power controller 126 (for example, a Eurotherm Model 1226e) connected to a thermocouple 127 which measures the temperature of the substrate mount 107. Such an arrangement of heated substrate mount, power supply, and power supply controller enables the temperature of the substrate mount, and hence the substrate, to be maintained at a desired value. Measurement of the temperature of the substrate surface [for example by pyrometry of the surface of the substrate 108] may provide greater control, particularly when the substrate is thick. The substrate 108 is held against the substrate mount by three spring loaded pins [not shown] but any other suitable means may be used.

A second RF generator 128 (for example Dressler Model Cesar) is attached to the substrate mount 107 through a second matching network 129 (for example Dressler Model Cesar)

Mass flow controllers 130 (for example Unit Instruments Model UFC 1000) controller the supply of gases 131 to gas inlets 112 (shown in Fig. 1).

A shutter 132 is provided between the plasma generator 106 and substrate mount 107. Contaminants and vapour are inhibited or prevented from deposition on the substrate 108 by the shutter 132. The shutter also serves to inhibit deposition from the substrate onto the hollow cathode during plasma etch cleaning of the substrate prior to deposition, and inhibit deposition from the hollow cathode onto the substrate while the hollow cathode plasma reaches equilibrium.

The shutter 132 may be provided with a periscope (not shown) for internal inspection of the apparatus as described below.

Vapour generator power supply 133 supplies power to the vapour generator 105.

### Alternative arrangements

In the example apparatus of Figs. 1 to 4, a single vapour generator, and a single plasma generator having a single space are described, but the invention is not so limited. For example:-
- a single vapour generator may feed a plasma generator having more than one space
- a single vapour generator may feed more than one plasma generator having one or more spaces
- more than one vapour generator may feed a single plasma generator having one or more spaces
- more than one vapour generator may feed more than one plasma generator having one or more spaces.

In the example apparatus of Figs. 1 to 4, a single substrate is shown mounted on a single and fixed substrate mount but the invention is not so limited. The invention contemplates:-
- multiple substrates being mounted on a single substrate mount;
- movable substrate mounts [for example mounts that may be rotated or slid]
- movable substrate mounts and air locks to permit removal of the substrate from the apparatus while still under vacuum.

Much expertise in the handling of substrates has been developed in the field of semiconductor processing and the invention contemplates the use of any and all known technology that can be usefully applied to the present invention.

### Typical operation of the apparatus of Figs. 1 to 4

The apparatus can be operated in the following general steps, realizing that modifications can be made in the steps and procedure and still accomplish the purposes/features of the present invention. A substrate 108 may be mounted on substrate mount 107 and a condensed phase source of material [e.g. gallium or aluminium, alloys thereof, or other desired components] can be placed in crucible 135. The shutter 132 would be in place between the vapour generator 105 and substrate 108. The system would be pumped down to evacuate the upper and lower chambers 101,102. A typical pressure in the chambers at this stage would be about 10⁻⁶ Torr, though other pressures above and below this may be used.

Once down to pressure, and in either order the following can be done:-
- Power supply 125 would be turned on to supply heat to the substrate 108 to get it to an appropriate temperature for the desired product. For instance, for deposition of crystalline AlN 850°C can be used, although other temperatures can be used, and the appropriate temperatures may depend on the substrate and the deposited material.
- RF generator 128 would be turned on to supply RF to the substrate 108 (resulting in a DC bias, as is conventionally known) and argon would be introduced into the chamber through one or more of the gas inlets 112. The Ar (or other inert gas) pressure in the upper chamber may be 5x10⁻³ to 10⁻³ Torr (666.6 to 133.3 mPa) and the applied RF power may be ∼ 50-100 watts resulting in a substrate bias of 250-300 volts although voltage in the range 300-400V may be used.

This serves to get the substrate 108 to a suitable deposition temperature, and to clean the substrate by Ar bombardment. The bombardment can typically proceed for 5 to 10 minutes. Inert gases other than argon [e.g. Ne, Kr or Xe] may be used in the cleaning step as may mixtures of inert gases.

The argon supply would then be turned off and the RF generator 128 turned off.

Vapour generator power supply 133 would then be turned on and the electron beam current increased to start heating of the condensed phase source of material. Typically the aim is to increase the condensed phase source of material to a temperature at which it is molten, and has a usefully high vapour pressure for deposition, without splashing the material through excessive boiling or outgassing of impurities or trapped gases. It can be useful to be able to observe the condensed phase source of material to ensure appropriate heating. For example, if the vapour generator is an electron beam device [for example as shown in Fig. 3], it can be useful to observe the incidence of the electron beam on the condensed phase source of material to ensure proper alignment. A periscope in the shutter or situated in the lower chamber 102 may be used for this purpose.

During this heat up process, surface contaminants on the condensed phase source of material may be vaporized. Contaminants and vapour are inhibited or prevented from deposition on the substrate 108 by the shutter 132.

Once the condensed phase source of material is molten, contaminants produced on the condensed phase source of material are either vaporized or sink or float to the edges of the molten material.

Argon, or any other inert gas such as Ne, Kr, Xe or others, can be injected over the material to be evaporated in the E-beam. The argon or other inert gas reduces the possibility of the reactant gas reacting with the molten surface material. Typically, without this argon blanket over the molten metal surface, AlN forms on the surface preventing the Al vapour from leaving the molten surface, and the AlN on the surface is sputtered by the E-beam causing particles of Al + AlN to be ejected from the E-beam source onto the substrate. These same procedures can be implemented with other source materials as described herein to protect the source material during melting and vaporizing.

One or more reaction gases [e.g. for nitride production N₂, NH₃, N₂H₂, or other nitrogen hydrides or nitrogen containing compounds; for oxide production, gases containing oxygen; for fluoride production fluorine containing gases; for mixed products [e.g. oxynitrides] a single gas comprising the required elements or a mixture of gases may be used] may be introduced into the upper chamber through one or more of the gas inlets 112. Some argon may also be introduced into the reaction chamber to assist in bombardment of the substrate 108, as this may improve the properties of the deposited material. A typical pressure in the upper chamber 101 would be about 10⁻⁴ to 10⁻² Torr (13.3 to 1333.2 mPa) [for example 1x10⁻³ to 5x10⁻³ Torr; 1x10⁻³ to 2x10⁻³ Torr; or 3x10⁻³ to 5x10⁻³ Torr (133.3 to 666.6 mPa; 133.3 to 266.6 mPa; or 400.0 to 666.6 mPa)]. The pressure experienced in the lower chamber 102 would normally be less, for example about half or between a fifth and a tenth that for the upper chamber 101. For example, the pressure might be in the range 1x10⁻³ to 2x10⁻³ Torr (133.3 to 266.6 mPa) in the upper chamber and 3x10⁻⁴ to 5x10⁻⁴ Torr (40.0 to 66.7 mPa) the lower chamber, though other pressures and pressure differences between the two chambers can be used.

The operating pressure of the vapour generator can be less than 5 x 10⁻⁴ Torr (66.7 mPa) and the operating temperature of the plasma generator can be 1 to 2 x 10⁻³ Torr (266.6 mPa) with an evacuation rate of >1000 l/min. A reactant gas feed rate (if used) can be 2-5 sccm (or above or below this range), and an inert gas feed rate to blanket the melt (source material) can for example be 10 sccm or less. These are examples and other amounts can be used for any of these ranges. Once the upper chamber 101 is at pressure, RF generator 128 can be turned on to supply 15-25 watts resulting in an RF bias of 80-150 volts to the substrate 108; and RF generator 123 turned on to supply RF to the cathode of the plasma generator 106. A typical bias for RF generator 123 is ∼ 350 volts.

The RF applied to the vapour generator initiates a plasma discharge 111 in the space 110 resulting in ionization of the gases present, and the discharge may extend out of the confines of the space 110 towards either or both of the vapour generator 105 or substrate 108.

Vapour 114 from the vapour generator 105 can react with the ionized gases in plasma 111. For instance, in the case of Al as the source material and nitrogen as reactant gas, AlN starts to form on the shutter 132. On removal of shutter 132 the vapour 114 and/or plasma 111 can reach the substrate 108 and commence deposition on the substrate. Application of RF bias to the substrate results in localised plasma generation and assists in bombarding the surface of the depositing material. For amorphous deposition it is preferable that no bias is applied to the substrate.

The rate of deposition can be measured [for example by using a deposition monitor, for example an Inficon Model U200]. Deposition temperatures have been used from 400-1100°C depending on the substrate material and deposition rates have been from 0.1 to 60 µm per hour, typically 40-60 µm per hour, although the invention is not limited to these temperatures or deposition rates.

Once the deposited material has reached a required thickness or depth the following may be done:-
- the shutter 132 is closed
- the RF supplies to the substrate mount 107 and plasma generator 106 are turned off
- all gases are turned off
- the heater to the substrate mount 107 is turned off
- the power to the vapour generator turned is off [this is best done slowly to avoid voids forming in the solidifying material]
- nitrogen is injected into the vacuum chamber to atmospheric pressure
- the vacuum chamber is opened when the substrate temperature is less than 500° C
- the substrate 108 is removed [optionally after cooling for an appropriate time]

The above describes a procedure with the apparatus shown. It will be evident that the apparatus can be used in different ways depending upon the nature of the material to be deposited. For example, the constitution of the gases may vary during the process, and the constitution of the vapour may be varied, for example by switching between alternative vapour sources. Control of the process can be automated, for example by computer control such as National Instruments LabVIEW.

### Specific examples of deposition process

### Example 1.

Aluminium nitride was made by placing pure Al (5 nines purity) in the crucible of the apparatus of Figs. 1 to 4. A silicon substrate was secured to the substrate mount. The substrate 108 , which can be Si or other material, was mounted to the chuck 107 and heated to typically 850°C.
[Generally, and not limited to or by this example, the substrate is heated to a temperature below the melting or deposition temperature of the substrate material, which can usefully be well below the melting temperature to avoid warping if the coefficient of expansion for the substrate and film are significantly different, such as more than 20% or more than 30%.
Generally, typical substrate temperatures are anywhere from 250-1000°C depending on the substrate material and the required crystallinity of the deposited material [e.g. AlN]. Typical temperatures for deposition of AlN on various substrates include but are not limited to 300°C ± 50°C for deposition on copper and aluminum and 800°C ± 50°C for deposition on Si, SiC, and aluminium oxide (sapphire)
The present invention is not limited to these temperature ranges or materials and further examples of suitable materials are given below.]

NH₃, N₂ and Ar gases were introduced to the upper chamber 101 by gas inlets 112 (typical proportions were 50% NH₃, 35% N₂ and 15% Ar). The pressure in the upper chamber 101 was observed to be approximately 3-5x10⁻³ Torr (400.0-666.6 mPa) and in the lower chamber approximately 3-5x10⁻⁴ Torr (40.0 to 66.6 mPa) although pressures in the upper chamber 101 of approximately 1-5x10⁻³ Torr (133.3 to 666.6 mPa), and in the lower chamber approximately 3-7x10⁻⁴ Torr (40.0-93.3mPa) have been observed.

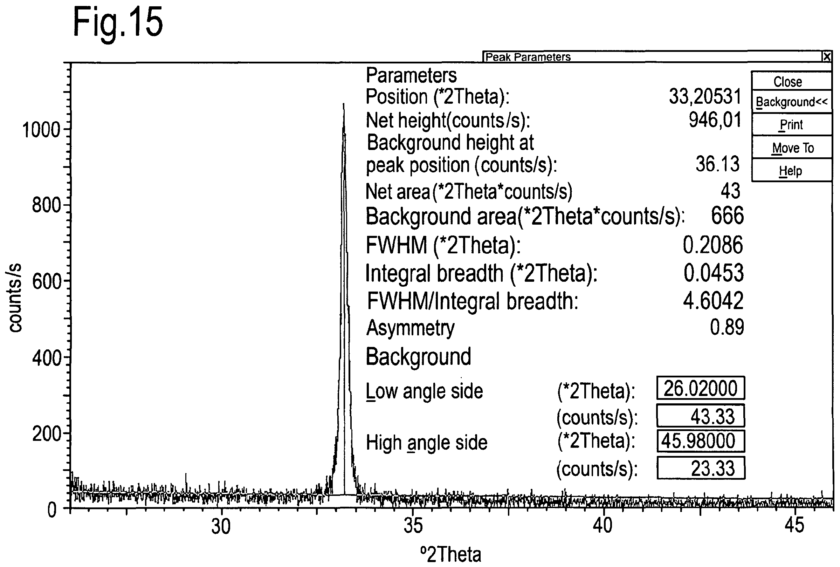

Growth rate shown was >40µm/hour and on occasion >80µm/hour and XRD of the deposited material showed hexagonal AlN. Fig. 15 is an x-ray diffraction [XRD] trace showing a 2 theta peak at 33 degrees, indicative of crystalline hexagonal AlN.

Following these procedures, AlN has been successfully deposited on Si, Al, sapphire, Mo, W, Nb, Ta, SiC, diamond, graphite, Cu, and Ta with no peeling or cracking in the machine. The deposited AlN films were transparent.

### Example 2

A metal or graphite or diamond sheet, or a crucible, was attached to a chuck above the electron beam hearth in the same vacuum chamber. The chuck was face down towards the electron beam hearth. The vacuum chamber was pumped down, typically < 5 x 10⁻⁶ Torr (666.6 µPa) and backfilled with Ar to 3 x 10⁻³ Torr (400.0 mPa). An RF generator, with any range, for example 13.56 MHz, was attached to the chuck and turned on, typically at 100 W, for 10 minutes to clean the substrate. The RF generator was turned off and the vacuum chamber again pumped down to < 5 X 10⁻⁶ Torr (666.6 µPa). The chuck temperature was increased to 800°C. The electron beam was turned on to melt the Al and bring the deposition rate to ∼0.3 nm/sec. This rate can be increased to the rates described herein by increasing the power of the electron beam. Ar was turned on at ∼ 3 sccm and NH₃ was turned on at ∼ 10 sccm resulting in a vacuum pressure of ∼ 6 x 10⁻⁴ Torr as measured in the lower chamber.

A RF generator, attached to the hollow cathode was turned on, which created a plasma and ionized the N₂. The RF generator attached to the chuck was also turned on which created a self bias on the chuck, typically 120-140 volts. This bias caused the Ar ions to bombard the AlN being deposited resulting in a very dense, crystalline film..

A shutter between the electron beam gun and the crucible was then opened. The shutter was opened typically for 15 minutes, resulting in ∼ 15 µm of AlN deposition. The shutter was closed and the electron beam turned off, the RF generators were turned off and gases turned off. The chuck heater was turned off. When the chuck reached 500°C, the vacuum chamber was back filled with N₂ to atmospheric pressure. The vacuum chamber was opened and the metal or graphite or diamond sheet, or crucible was removed.

The AlN coatings produced had excellent adhesion to metals, graphite and diamond such that the coated substrates were heat cycled to 1100°C with no cracking or peeling of the AlN. A graphite substrate with a 5 µm AlN coating that was heat cycled to 1100°C showed no degradation of the AlN film. A 15 µm film on a diamond coated silicon substrate that was heated to 1100°C showed no degradation of the AlN film. Such AlN coated, high thermal conductivity materials can be used in thermal management, as may other products produced by the method of the invention. Thermal management applications include heat conductors, heat spreaders, and heat sinks. The substrates for such applications may be, but are not limited to, Cu, Al, diamond, graphite, pyrolytic graphite, or silicon carbide.

Following essentially the same procedures,
- AlN has been deposited up to 15 µm thick onto Cu with no cracking or peeling of the AlN.
- AlN has been deposited up to 15 µm thick onto diamond with no cracking or peeling of the AlN.
- AlN has been deposited at thicknesses ranging from 100nm to 150 µm onto silicon wafers with no cracking or peeling.

Greater thicknesses are readily achievable.

In these tests adhesion was measured by a "tape peel test', wherein the deposited AlN film was scratched with a diamond scribe with enough pressure to break through the deposited AlN. Adhesive tape was then pressed onto the scratched area. The tape was then peeled off the surface and the scratched area examined with a microscope at 100x to see if any of the deposited film had peeled off the substrate. This test has been done on AlN deposited on Si, Ta and Cu and has shown there is no peeling of the AlN using the tape peel test.

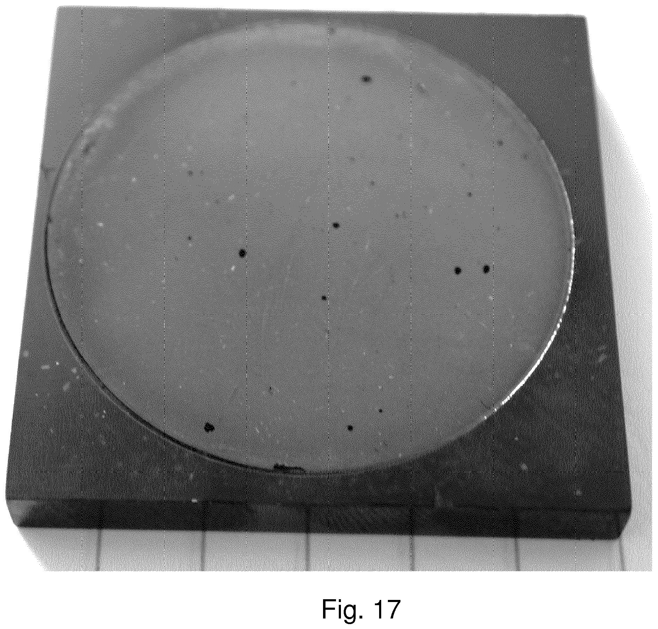

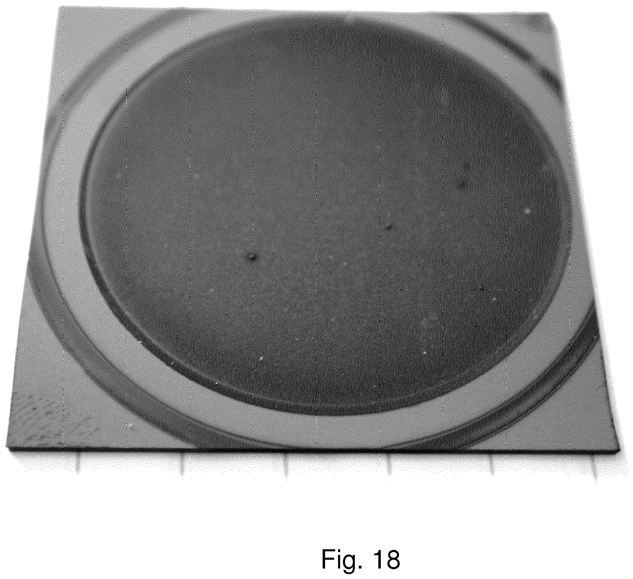

Fig. 17 is a photograph of a graphite substrate with a 5 µm AlN coating and Fig. 18 is a photograph of a 15 µm AlN coating on a diamond coated silicon substrate. In both cases the coating showed no degradation after heating to 1100°C, showing the adherent nature of the AlN coating.

AlN has been deposited onto a refractory such as SiC with excellent adhesion and no cracking or peeling of the AlN.

With the present invention, an intermediate region can be present between the deposited material and the substrate. This intermediate region may have a different composition or structure than the deposited material or the substrate itself. The intermediate region may be a reaction product of one or more components that form the deposited material and one or more components that form the substrate.

For example, when aluminium nitride was deposited directly on silicon, and the silicon substrate subsequently dissolved away, it was seen that a blackened layer did not dissolve away and this blackened layer was different from the transparent aluminium nitride formed on top, thus confirming the presence of an intermediate layer presumed to be a reactant product between the silicon and the aluminium nitride.

This intermediate region can occur through reaction in the initial stages of deposition, with the remaining thickness of the deposited material forming on top; or it may occur through subsequent reaction of deposited material with the substrate; or indeed it may be a separately applied layer, which optionally may have a distinct difference in chemical composition from either substrate or deposited material [as exemplified, for example, in the AlN coating formed on a diamond coated silicon substrate of Fig. 17].

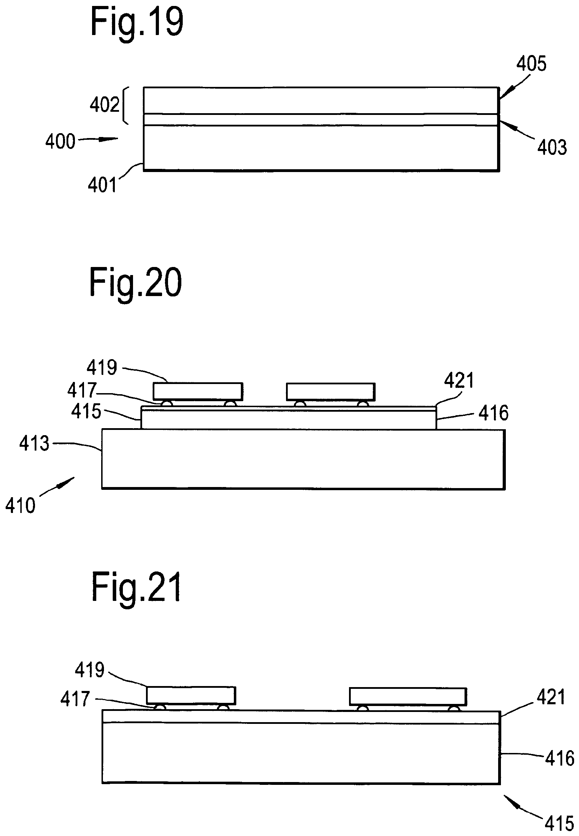

Fig. 19 shows an example of a layered design. In Fig. 19 (not to scale), a laminate 400 is shown. A substrate 401 can have a layer 402 adhered to a surface of the substrate as shown in Fig. 19, for instance. The layer 402 can have an intermediate region 403 sandwiched between a deposited layer 405 and the substrate 401. Intermediate 403, may have a different composition or chemical make-up than the deposited layer 405. The intermediate region 403 can be a reaction product of one or more components that form the layer 405 and one of more components that form the substrate 401.

As an example, without limiting the present invention, substrate 401 can be copper or sapphire or silicon, for instance, and layer 405 can be AlN, wherein intermediate region 403 would comprise a reaction product of aluminium, nitrogen, and/or aluminium nitride with one or more components that comprise the substrate, namely, the sapphire, silicon, or copper. Both intermediate layers may be formed through reaction with the substrate, and deliberately formed intermediate layers. Such laminates can be used as heat sinks for thermal management.

As an example, aluminium nitride as a layer that is deposited on a metal substrate or ceramic substrate or glass substrate can provide excellent thermal management properties due to the properties of aluminium nitride. For instance, the layer can have a thermal conductivity of 210 W/mK to 319 W/mK, such as from 210 to 275 W/mK or 210 to 250 W/mK.

The aluminum nitride located on the substrate can have one or more of the following additional properties:

| | | |
|---|---|---|
| Flexural Strength | MPa (lb/in²x10³) | 320 (46.4) |
| Elastic Modulus | GPa (lb/in²x10⁶) | 330 (47.9) |
| Poisson's Ratio | - | 0.24 |
| Compressive Strength | MPa (lb/in²x10³) | 2100 (304.6) |
| Hardness | Kg/mm² | 1100 |
| Knoop hardness | 100 gm load, HK 0.1,10 | 1412 ± 143 |
| Fracture Toughness K_{IC} | MPa•m^{1/2} | 2.6 |
| Coefficient of Thermal Expansion | 10⁻⁶/°C (10⁻⁶/°F) | 4.5 (2.5) |
| Specific Heat | J/Kg•°K (Btu/lb•°F) | 740 (0.18) |
| Dielectric Constant | @ 1 MHz | 9 |
| Volume Resistivity | ohm•cm | >10¹⁴ |

Hardness has been measured of a 30µm AlN coating on silicon by using a Knoop indenter and taking the average of ten indents at 100 grams load. This showed a microindentation hardness measured was 1412 ± 143 HK 0.1,10.

Dielectric strength has been measured for 200nm and 500nm thick coatings of AlN on silicon after an 800°C anneal. The dielectric strength was found to be in the range 1-3 MV/cm. Thermal management may be for any device, for example as an electronic device, like a CPU, light radiation emitting device (e.g. LED), phone, smart device, and the like. For instance, the laminate 400 may comprise a layer of material adhered to a substrate, with either or both the layer and substrate being of high thermal conductivity material. For example, a material such as aluminium nitride adhered to a metal substrate like copper, can be used as a heat sink in lieu of, for instance, a printed circuit (PC) board or mount (or sub mount) which typically are made from a polymer material or resin and are not good conductors of heat. Other substrates with high thermal conductivity include, for example and without limitation, other metals, graphite, and diamond. One or more chips, such as integrated circuits (ICs) or computer chips, can be connected to the laminate through interconnects or bumps, and, due to the dielectric nature of the layer (for instance, aluminium nitride), the interconnects or bumps can be made out of metal without any need for separate insulation layers.

As an alternative, the laminate heat sink can be located on a mount or PC board or be the mount or PC board itself.

In another option, the laminate heat sink can be a heat sink for a light-emitting diode device, wherein a dye(s) is located on the heat sink and, again, due to the dielectric nature of the layer used for the laminate heat sink of the present invention, no separate insulator is needed between the dye and the heat sink.

Figs. 20 and 21 show an example of these features. As shown in Fig. 20, an assembly 410 comprising a mount or PC board 413 with mounted IC chips 419 is shown.

The mount or PC board 413 can have the laminate of the present invention 415 located on top and adhered to the mount or PC board 413. The laminate 415 can comprise a substrate 416, which can be any of the substrates identified above, but for this embodiment, the substrate preferably is a good thermal conducting substrate such as copper.

Located on the substrate is a layer 421, for instance, of aluminium nitride or other material that has a good thermal conductivity. The bumps 417 from the IC chip or other electronic part can be connected to the layer 421 for purposes of securing the chip 419 and providing good thermal connectivity.

In an alternative example, Fig. 21 shows where the laminate 415, which has a substrate 416 and a thermal conducting layer 421, can serve as the mount or PC board itself. One or more IC chips 419 can be attached to layer 421 by bumps 417.

Although bumps are shown in Figs. 20 and 21, other means of providing good thermal conductivity between the IC chips 419 and layer 421 are contemplated, for example metallic or other high thermal conductivity layers or direct contact between the IC chips 419 and layer 421.

### Example 3

In the apparatus of Figs. 1 to 4, a crucible 135 is shown. Conventionally the depression 134 may be a water cooled copper hearth, with the metal placed directly in the hearth. However this arrangement is energetically inefficient as a lot of heat is lost to the water cooling. Refractory crucibles, for example of graphite, tantalum, niobium, or tungsten, may be used in the hearth, which reduces the energy required to melt the desired material, typically by a factor of the order of 10. However, such crucibles can cause problems due to wetting of the crucible surface with molten metal (e.g. aluminium). The molten metal wets to the crucible material and flows up the crucible wall and over the top causing a thermal short to the water cooled hearth. In addition, when the metal wets to the crucible material, the crucible typically cracks due to the thermal expansion mismatch between the melted material and the crucible.

The inventors have found that coating refractory crucibles [e.g. of tantalum, niobium, molybdenum or tungsten] with AlN or similar layers reduces or prevents the wetting of the melted material to the crucible, which in turn prevents the molten metal from flowing up the crucible wall and causing a thermal short. In addition, the non-wetting prevents the crucible from bonding to the melted material and thus the crucibles do not crack with repeated heating and cooling cycles.

Refractory materials that may be used for forming crucibles include refractory metals or carbon.

Refractory metals on one definition are those with a melting point above 1850°C [Ti, V, Cr, Zr, Hf, Ru, Rh, Os, Ir, Nb, Mo, Ta, W, Re], and on another definition those exceptional metals with a melting point above 2200°C [Nb, Mo, Ta, W, Re]. The use of any or all of these elements and alloys [both between these elements and/or with other elements] that have a melting point above 1850°C or 2200°C respectively may be contemplated. The use of materials other than refractory materials, depending on what is melted in the crucible, may be contemplated. For instance, a stainless steel crucible can be used and coated with AlN as described herein and then used for melting material, such as Al.

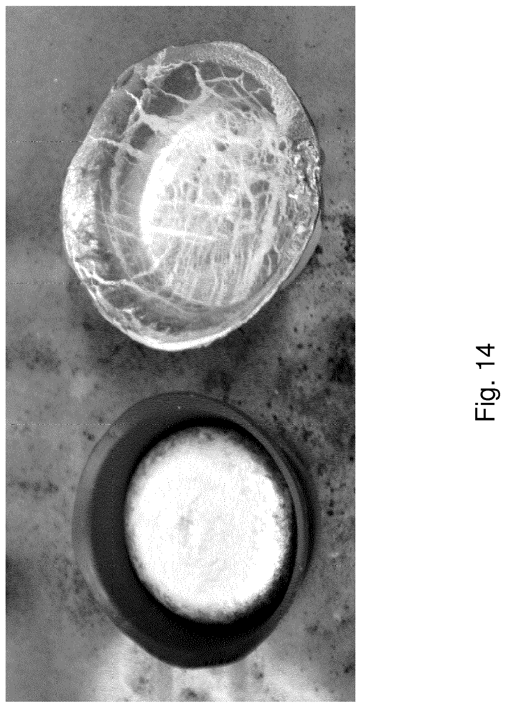

In tests, a tantalum crucible was coated with AlN by using it in place of a substrate in the apparatus of Figs. 1 to 4. When subsequently used as the crucible in the apparatus of Figs. 1 to 4 the AlN-coated tantalum crucible showed little wetting by aluminium and reduced the energy required for the electron beam to about a tenth of that required when melting the material directly in the water cooled hearth. Fig. 14 shows on the right an uncoated pressed tantalum crucible after melting of aluminium, and it can be seen that the aluminium has wetted the crucible and covered its entire surface. On the left, Fig. 14 shows an AlN coated crucible showing that the aluminium has not wetted the crucible, and instead has formed a lump.

In addition to tantalum, AlN has been proven in similar experiments to have excellent adherence to many substrate materials such as Cu, Si, W, Nb, Mo, Ta, graphite and diamond. AlN has been successfully deposited onto Ta, Nb, Mo and W crucibles used in electron beam evaporation of Ag.

A W crucible coated with 10 µm of AlN was tested in an electron beam system in which high purity (4 nines) Ag was evaporated. It was found that while largely non-wetting the molten Ag had dissolved some of the AlN coating.

Au was melted and cooled a number of times in a AlN coated crucible over a period of several months with no wetting of the Au to the AlN coating.

Another W crucible coated with 10 µm of AlN was placed into a vacuum oven and heated to 1100^{o}C in forming gas(5% H₂ in N₂) at (2.66 Pa) for 1 hour and then in air at 20 mTorr for an additional hour. The AlN coating on the W crucible showed no cracking or peeling after this heat treatment. The heat treated AlN coated W crucible was tested by evaporating Ag in an electron beam system. There was no degradation of the AlN in contact with the molten Ag. This test was performed several more times with no reaction of the Ag with the AlN.

It is suspected, although the applicant does not wish to be bound by this hypothesis, that the AlN is at least partially oxidized in the heat treatment, perhaps to form, in part at least, an aluminium oxynitride. A process may be contemplated in which an applied nitride coating, particularly although not exclusively an AlN coating, is further modified through exposure at elevated temperature to an oxygen containing material. The material may be an oxygen containing gas or may result from contact with a liquid or solid oxygen-containing reactant. Further, oxidation may be part of the process of deposition, for example by introducing oxygen-containing gases [e.g O₂, H₂O or nitrogen oxide] during the final stages of deposition of the AlN. Heat treatment (with or without oxygen present) may be contemplated to anneal the coating. Heat treatment temperatures for AlN may be at any useful temperature below the melting or deposition temperature of the substrate and may be, for example, above or below 500°C, above or below 750°C, above or below 1000°C, above or below 1250°C, above or below 1500°C, above or below 1750°C , above or below 2000°C, or within any range defined by these temperatures or outside these temperatures. Complete oxidation of the AlN to provide an aluminium oxynitride throughout the coating may be contemplated.

Al was melted and cooled in an AlN coated crucible (Ta) in an E-beam system 96 times. The Al adhered to the AlN coated crucible but did not wet up the sides of the crucible. There was no evidence of the AlN coating cracking or peeling after the 96 cycles. There was also no evidence of the Ta cracking.

Reducing surface roughness before coating assists in reducing defects in the coating. For example excellent coatings with no defect have been obtained by electro polishing the crucibles prior to coating to obtain a very smooth surface prior to coating. It is believed that surface roughness does not necessarily improve adhesion but high surface roughness can cause defects in the AlN coating.

Whereas tantalum and niobium crucibles are commonly made by machining from bulk and are hence expensive, the inventors have found that these materials may be pressed from sheet material and used to form crucibles.

US7056383 discloses tantalum crucibles that are machined from 99.9% pure tantalum, carburised to form a carbide surface and then treated to produce a tantalum nitride coating over the carburised surface. Using pressed tantalum or niobium to make coated crucibles without the need for a carburised surface may be contemplated.

In the apparatus of Figs. 1 to 4, a crucible is used having a mouth at its upper end and a closed lower end. Such a crucible has only a limited capacity and to provide a more continuous process means to provide additional material to the crucible are desirable. Supplying more material by insertion into the mouth of the crucible is possible, but runs the risk of interfering with the evaporating surface of the material being evaporated. Providing an aperture, for example at the bottom or side of the crucible, to permit more material to be inserted into the crucible below the evaporating surface of the material being evaporated permits a continuous supply. There are E-beam sources available that can be rod fed from the bottom or wire fed from the top.

US5534314 discloses a process in which a carrier gas stream is provided, in effect to stream evaporated material to a substrate. Such a process could be used in combination with the present process by introducing gas at the lower end of the plasma generator 106. US5534314 discloses a process in which no crucible is used, but a rod of material is provided for evaporation by an electron beam. Rod fed evaporation could be used in conjunction with the present apparatus. A rod could be fed into a crucible as disclosed above.

The material being evaporated may be elemental or an alloy.

The combination of vapour generator and plasma generator together constitute an ion beam gun that may have wider applicability than in the methods and apparatus described herein. The process described above may be used generally to produce laminated articles comprising one or more deposited layers on a substrate. Although in the examples above metals, graphite, silicon carbide, silicon and diamond-coated silicon have been mentioned as potential substrates for deposition of layers, the invention has wider applicability and encompasses deposition on any substrate capable of receiving an adherent deposit without material damage to the substrate.

Typically, the substrate may have a melting or decomposition temperature of over 200° C, or over 300° C or over 400° C. Substrates may include, for example, a metal, glass, ceramic, glass ceramic, or polymer, as long as the melting temperature of the substrate is high enough to resist damage in the process of deposition. The substrate may be crystalline, partially crystalline, or amorphous. If a polymer is used it may be thermoset or thermoplastic although thermoset polymers may be better in resisting damage in processing.

More specific examples of substrates include, but are not limited to, the following:
aluminium, boron, carbon, chromium, cobalt, copper, gold, hafnium, iron, lead, magnesium, manganese, molybdenum, nickel, niobium, platinum, silicon, silver, tantalum, tin, titanium, tungsten, zinc, and zirconium, or compounds containing one or more of these elements, such as oxides thereof, nitrides thereof, carbides thereof, ceramics thereof, and the like.

More specific examples of substrate include, AlN, copper, aluminium, diamond, glass, silicon carbide, silicon, silica, graphite, pyrolytic carbon and the like. Substrates may also comprise any of these materials [or any other material] having a coating of these materials. Such products may be used in thermal management, as described above.

By adherent deposit is meant a deposit that exhibits no cracking or peeling in ordinary use of the laminated article. This can include no cracking or peeling occurring even after the substrate with the adhered deposit has been exposed to high temperatures, such as temperatures that are within 20% of the melting temperature of the substrate or layer (whichever is the lower) even after return to a lower temperature [e.g. 25°C]. Adherence can be tested by other methods [e.g. cycling between a lower and a higher temperature].

The deposited layers adhered to the substrate(s), can have low oxygen contents when oxides are not intended. For instance, a metal or metal nitride or other non-oxygen containing layer can be deposited on a substrate(s), wherein the layer has a low oxygen content. The oxygen content for such layers can be under 300 ppm, such as from about 1 ppm to 299 ppm, or 3 ppm to 100 ppm, or 1 ppm to 100 ppm, or 1 ppm to 10 ppm, and the like. Due to the processes of the present invention, other impurities, such as gaseous impurities and/or metal impurities, can be very low. For instance, if using a source material that is vaporized that has a very high purity, such as 99.999% or 99.9999% purity, all other impurities (gaseous and/or metal or total other impurities) in the layer can be below 10 ppm, can be below 5 ppm, can be about 1 ppm or 1 ppm, such as from 1 ppm to 5 ppm.

With the present invention, the layer deposited on a substrate can have excellent coating uniformity, for example as low as ± 5% throughout the entire deposited surface of the substrate. For the interior of convex shapes such as crucibles the coating uniformity tends to be less uniform, but a uniformity of ± 10% has been achieved. The uniformity was assessed using an SEM to examine different areas.

With the present invention, the deposited layer on the substrate can have no observable voids or pin holes at a magnification of 300 X or 500 X. The deposited layer adhered to the substrate can have any desired thickness, such as from about 0.1 micron to 2 mm or more, such as 0.1 micron to 2 mm, 0.1 micron to 1 mm, 10 microns to 500 microns, 10 microns to 100 microns, and the like.

The substrate, prior to having a layer deposited on it, can be pre-treated with any conventional techniques, such as cleaning the surface, acid treating, polishing (e.g., electropolishing) the surface, and the like. These various cleaning or polishing steps can be done using any conventional technique associated with a substrate material. Similarly, after the layer is deposited on the substrate, the laminate which can have any shape, can be subjected to any number of post-treatments, such as, but not limited to, cleaning treatments, heat treatments at any various temperatures or pressures, passivated, or otherwise treated with liquids or gasses (nitrogen and/or oxygen, halides, and/or air at optional room and/or elevated high temperatures, and/or at optional elevated pressures).

### High pressure press

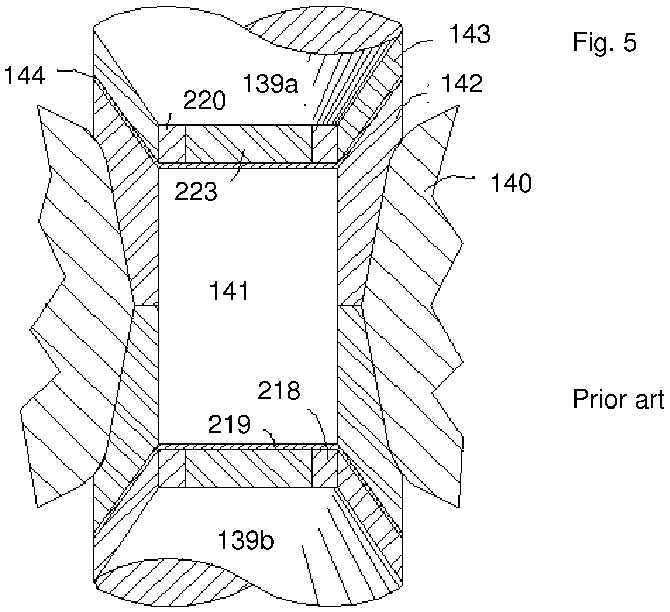

A high pressure press as described in the following does not form part of the claimed invention, but may be used to further process materials manufactured in a method according to the present invention. A typical process chamber of a belt press is depicted in Fig. 5. Tungsten carbide punches or anvils 139a, 139b, and a tungsten carbide belt 140 enclose a process chamber 141 and are electrically and thermally insulated from the process chamber 141 by insulating gaskets 142 and 143. Gaskets 142 and 143 are separated by a metal foil 144. The insulating gaskets 142 and 143 are typically made of a material such as pyrophyllite. Pyrophyllite has the unusual property in that it will flow under pressure and yet has enough friction with the carbide punch or anvils 139a and 139b and the carbide belt 140 that will prevent the pyrophyllite from continuing to flow as the space between the punch or anvils 139a and 139b and the carbide belt 140 has decreased to approximately 1-2 mm as pressure between the punch or anvils 139a and 139b is increased.

The use of pyrophyllite allows the compression of the process chamber 141 and allows for electrical isolation between the punch or anvils 139a, 139b and the carbide belt 13. The pyrophyllite also allows for some thermal insulation between the hot process chamber 141 and the punch or anvils 139a, 139b and the carbide belt 140. The thermal insulation between the process chamber 141 and punch or anvils 139a, 139b and the carbide belt 140 is minimal as the space between the process chamber 141 and punch or anvils 139a, 139b and the carbide belt is limited to approximately 1-2 mm. A space larger than 1-2 mm between the process chamber 141 and punch or anvils 139a, 139b and the carbide belt 140 would allow the pyrophyllite to continue to flow as the pressure is increased, and would thereby prevent the pressure increasing to greater than 7GPa (70 kbar) required to manufacture synthetic diamonds. Such a thin layer of pyrophyllite does not sufficiently thermally insulate the carbide members from the heat of the process chamber. The belt press can only be used at temperatures > 1500°C for very short times, such 5 -10 minutes, before the carbide members reach 600°C and begin to fail.

Conventional belt press geometries therefore do not provide sufficient thermal insulation to the press parts and cannot be modified to provide added insulation simply by increasing gasket thickness. This problem may be overcome through the use of a press in which a punch is movable to enter a divergent press cavity from a narrower end of the cavity.

Accordingly, a press for high pressure, and optionally high temperature, treatment of materials, comprises a first press assembly having a cavity broadening from a mouth, and a punch mounted on a second press assembly such that relative motion between the first press assembly and second press assembly can move the punch into the cavity from the mouth.

The cavity may be defined by a ring having a through hole and a closure closing an end of the hole remote from the mouth.

The cavity may be a frusto-conical cavity.

The cavity may narrow after broadening from the mouth.

The cavity may be formed from two opposed cavities.

Within the cavity a thermally insulating liner may be provided having an outer surface shaped to conform to lateral surfaces of the cavity and an inner surface shaped to receive a process chamber housing material to be treated under pressure.

The process chamber may comprise an electrical resistance heating element and conductors may be provided in the cavity to permit transmission of current to the electrical resistance heating element.

The thermally insulating liner may be made from one piece, or in two or more sections of different materials, and may comprise a first section disposed towards the mouth of the cavity and a second section within the cavity adjacent the process chamber, in which the first section has a lower compressive strength at a specified temperature and lower thermal conductivity at said specified temperature than the second section. The thermally insulating liner may further comprise a third section disposed between the second section and the lateral surfaces of the cavity, the third section having a lower compressive strength at said specified temperature and lower thermal conductivity at said specified temperature than the second section. The specified temperature may be, for example 1500°C, 1750°C or 2000°C.

The press may comprise channels for the passage of coolant.

The cavity may comprise carbide bodies mounted in a metal surround. The use of a thin gasket material is not required and therefore there is not a limitation of the space between the process chamber and the carbide components allowing for much greater thermal insulation between the process chamber and the tungsten carbide components. This allows for processing at temperatures > 1500°C, or example greater than 2000 °C, or greater than 2500 °C, such as from 1500 °C to 3000 °C. Carbide components [e.g. tungsten carbide components] are attached to water cooled steel holders allowing for the continuous removal of any heat transferred to the carbide components. This allows for processing at high temperatures for indefinite amounts of time as certain processes may require high temperature operation for days or weeks of continuous operation.

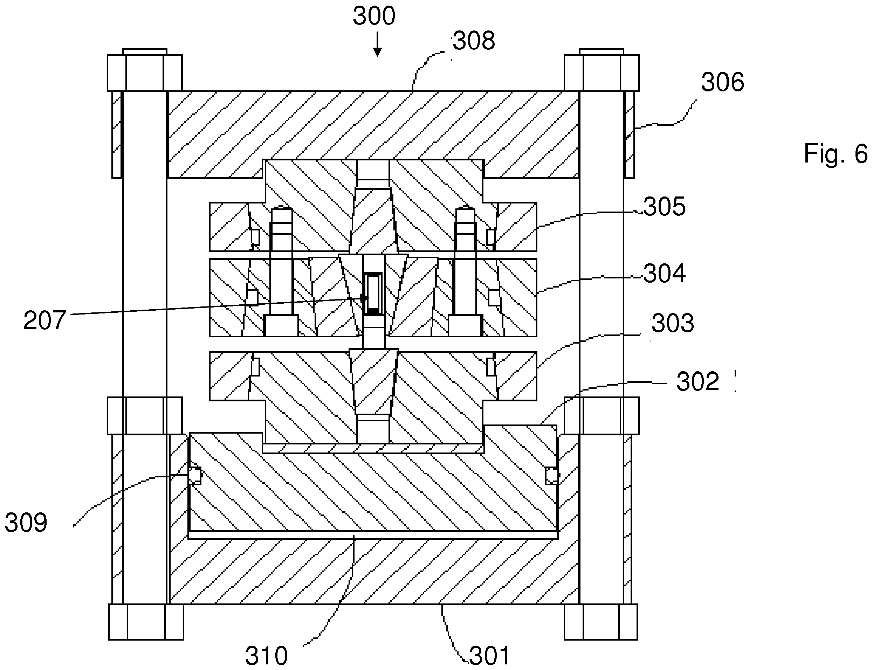

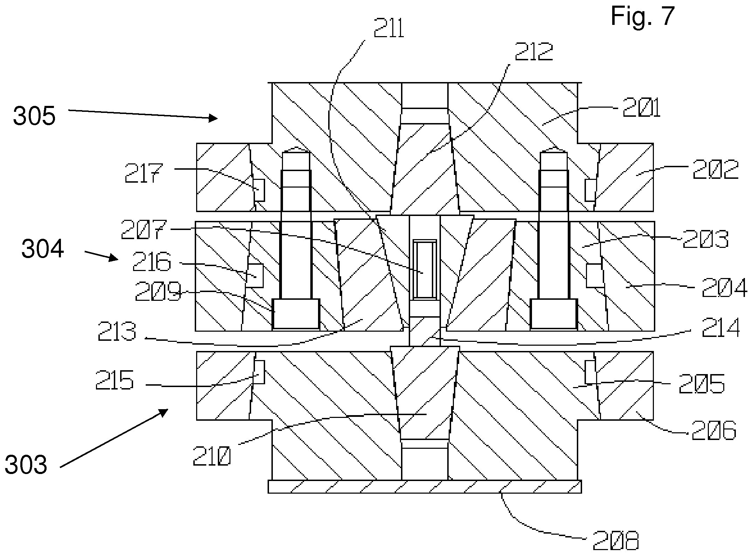

Referring to Figs. 6 and 7, a high pressure high temperature apparatus 300 comprises an upper press assembly 305, process chamber assembly 304 and lower press assembly 303 disposed between an upper plate 308 and piston 302 mounted in a piston cylinder 301.

The upper plate 308 and the piston cylinder 301 are constrained by bolts 306. The process chamber assembly 304 is contained between the upper press assembly 305 and lower press assembly 303. The process chamber assembly 304 is water cooled by a water channel 216.

The piston 302 is contained within the piston cylinder 301 and is sealed by an o-ring 309. High pressure hydraulic oil may be pumped into the space 310 between the piston 302 and the piston cylinder 301 to cause the piston 302 to rise and apply pressure on the lower press assembly 303 which in turn causes the punch or anvil 214, shown in Fig. 7, to compress the process chamber 207 to the appropriate pressure, typically 5-6GPa (50-60 kbar).

The appropriate pressure depends on the particular process required. Synthetic diamond production typically requires pressures in the range of 6 GPa (60 kbar) while single crystal production of GaN typically requires pressures of 5 GPa (50 kbar) using the apparatus as described above. US7294198 describes forming single crystal GaN in an HPHT apparatus. However the minimum pressure is stated to be 6GPa (60 kbar). The lower pressure required using the apparatus as described above is advantageous, as lower pressures are much easier to maintain when the temperatures approach or exceed 2000°C, or even 3000°C.

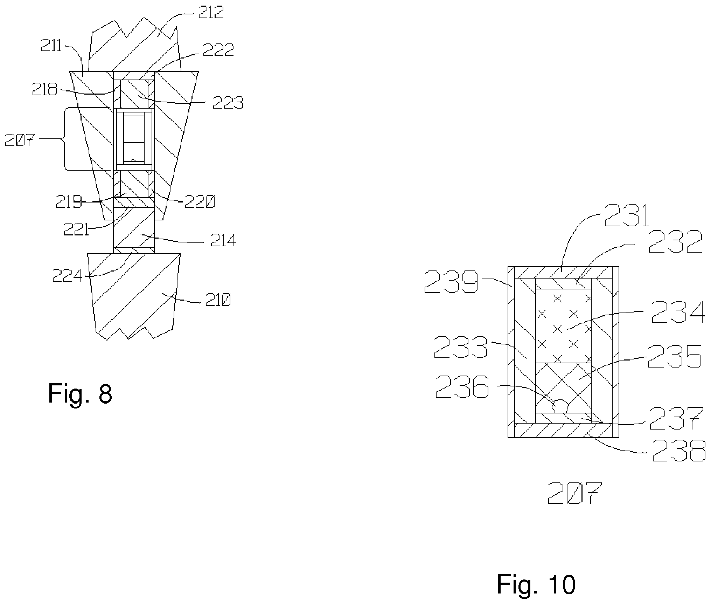

An electric current is passed through a graphite cylinder 239, shown in Fig. 10, which heats the process chamber 207 to the appropriate temperature depending on the particular process requirement, typically > 1200°C for diamond synthesis. The lower press assembly 303 is electrically insulated from the piston 302 by an insulator 208. Electrical connectors (not shown) are connected to upper press assembly 305 and the lower press assembly 303. An electrical current is passed through the lower insert 210 (which may be of carbide, e.g tungsten carbide) and through the punch or anvil 214 (which may be of carbide, e.g tungsten carbide) and through an electrically conductive disk 221 (for example a metal disk) shown in Fig. 8. The electric current then passes through an electrically conductive ring 220 (for example a metal ring), typically although not necessarily made of stainless steel tubing or tantalum foil or other refractory metals or even graphite, and through a heater 239 (typically of graphite) shown in Fig. 10 and through a second electrically conductive ring 218 normally although not necessarily of like composition to electrically conductive ring 220 and then through a second electrically conductive disk 222 and through the upper insert 212 (which may be of carbide, e.g tungsten carbide) and into the upper press assembly 305.

The electrically conductive disks 221 and 222 are typically although not necessarily made of iron (other electrically conductive materials, for example as exemplified for the electrically conductive rings 218 and 220, may be used) and spread the electrical current from the anvil 214 and upper insert 212 to electrically conductive rings 220 and 218 respectively. The electrically conductive rings 218 and 220 surround insulators 223 and 219 respectively. The insulators 223 and 219 have low thermal conductivity to prevent the high temperatures in the process chamber 207 from overheating the anvil 214 and the upper insert 212

The electric current passing through process chamber 207 is insulated by an insulating cone 211 from a compression ring 213 [which is typically made of carbide, e.g. tungsten carbide] having a conical inner surface. The insulating cone also provides thermal insulation between the process chamber 207 and the compression ring 213. The compression ring 213 may have a conical outer surface. The compression ring 213 is surrounded by a water cooled ring 203, which may be of steel. A water channel 216 is contained by an outer ring 204 which may be of steel. The outer ring 204 is heat shrunk around the water cooled ring 203 which is heat shrunk around the compression ring 213. The insulating cone 211 is pressed into the compression ring 213 by the carbide insert 212. The insert 212 is pulled against the insulating cone 211 by a circular pattern of 16 bolts 209 to pre-compress the insulating cone 211. This pre-compression of the insulating cone 211 reduces the amount of travel required by the punch or anvil 214 during the compression of the process chamber 207. In effect, a two stage compression is provided: first by clamping together the upper press assembly 305 and process chamber assembly 304; and then by insertion of the punch or anvil 214.

The carbide punch or anvil 214 is made as short as possible to maximize the strength of the punch or anvil: typically a 1:1 height to diameter ratio would be desired. However, this 1:1 ratio limits the allowable length of the punch or anvil 214 and therefore limits the allowable travel of the punch or anvil 214. It has been determined that height to diameter ratio can be as high as 3:1 and still hold up under pressure. Higher ratios are not precluded. The upper press assembly 305 and lower press assembly 303 are water cooled by water channels 215,217. The upper press assembly 305 has a carbide insert 212 [typically tungsten carbide] pressed into a water cooled ring 201. An outer ring 202 is heat shrunk around the water cooled ring 201 which contains the water channel 217. The lower press assembly 303 is constructed similarly to the upper press assembly 305 with outer ring 206 heat shrunk around water cooled ring 205 which contains water channel 215. The water cooled rings 201, 205 and outer rings 202, 206 may be made, for example, of steel.

Referring to Fig. 8, an electrically conductive disk 224 having ductility, such as a molybdenum or niobium disk may be placed between the punch or anvil 214 and the lower carbide insert 210 to prevent carbide to carbide contact between the carbide insert 210 and the punch or anvil 214. Without the electrically conductive disk 224, the carbide punch or anvil 214 is liable to break prior to reaching high pressures. Electrically conductive disk 221 221, preferably made of iron, is placed above the punch or anvil 214 to allow the electrical current to pass from the punch or anvil 214 to electrically conductive ring 220. The electrically conductive disk 221 also serves the purpose of sealing the chamber 207 from the atmosphere. As pressure is applied, the electrically conductive disk 221 will be reduced in thickness and expand against the insulating cone 211 and thereby seal the process chamber 207 from the atmosphere. Atmospheric components such as oxygen and nitrogen can contaminate certain materials used during processing. The second electrically conductive disk 222 seals the top of the process chamber 207 in similar manner. The electrically conductive ring 220 used to conduct the electrical current surrounds thermal insulator 219, which is preferably formed from a ceramic material such as pyrophyllite, zirconia, alumina, mullite, or mica. The thermal insulator 219 serves to reduce the heat conduction from the heated process chamber 207 to the carbide punch or anvil 214. A similar metal ring 218 with a thermal insulator 223 protects the carbide insert 212 from overheating. If the carbide punch or anvil 214 or the carbide insert 212 reach approximately 600°C, the carbide punch or anvil 214 or the insert 212 may fail under high pressure conditions.

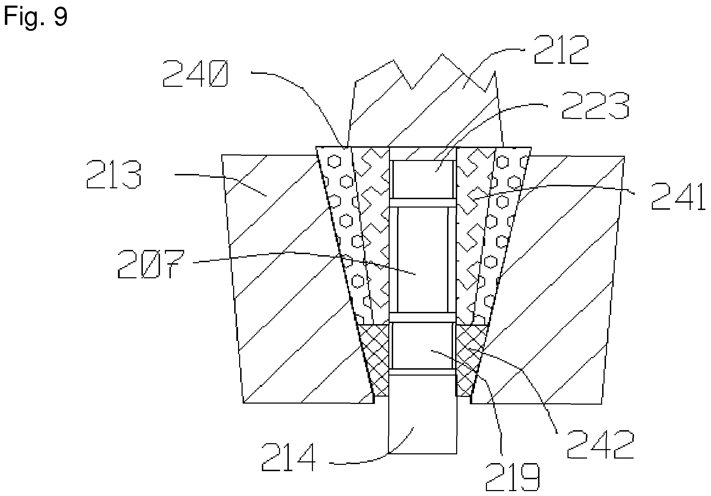

Fig. 9 depicts a further modification of the HPHT configuration. The ceramic insulation cone 211 has been partitioned into 2 or more sections. Shown is an insulating cone comprised of three sections 240, 241 and 242. Since the insulating cone can be made into sections, various materials can be used to make the entire insulating cone. For example, the lower section 242 of the cone 211 should have a low thermal conductivity and a fairly high compressive strength. Zirconium oxide is a good choice for the lower section 242. An inner cone 241 requires high compressive strength at very high temperatures. Aluminium oxide has high compressive strength at 2000°C while non-stabilised ZrO₂ rapidly loses strength above 1700°C.

The outer cone 240 has a high thermal resistance to prevent excessive heat transfer to the compression ring 213. Typically, very dense high strength materials such as aluminium oxide also have a fairly high thermal conductivity, for example 30-38 W.m⁻¹.K⁻¹. If the entire insulating cone is made of aluminium oxide the high thermal conductivity will conduct too much heat from the process chamber 207 to the compression ring 213 resulting in over heating of compression ring 213 which may cause the compression ring 213 to fail under high pressure conditions.

The ideal insulating cone material should have high thermal resistance, a high melting point and low compressibility. The inner cone 241 and outer cone 240 can be formed as one piece with the same material, however two or more part construction has advantages. Constructing the insulating cone 211 of several different materials permits optimization of the entire cone. For example, the cone can successfully be constructed to withstand temperatures of 2300°C or even up to 3000°C or more, and pressures up to 5-6GPa (50-60 kbar) by using SiC for the inner cone 241 and yttria stabilized zirconia or magnesium stabilised- or partially-stabilised-zirconia for the outer cone 240 and the lower section 242. Yttria stabilized zirconia has a very high compressive strength at temperatures below 2000°C. The SiC inner cone 241 protects the zirconia cone 240 from reaching 2000°C. SiC however has a high thermal conductivity of 70-120 W.m⁻¹.K⁻¹ and therefore for cannot be used alone at such elevated temperatures. ZrO₂ has a low thermal conductivity of 2 W.m⁻¹.K⁻¹ and therefore prevents the heat transfer to the surrounding tungsten carbide compression ring 213.

Materials that enable a one piece cone to work at elevated temperatures include zirconia and stabilised zirconias, for example yttria stabilised zirconia, and magnesium stabilised- or partially-stabilised- zirconia, the last of which appears to perform better than yttria stabilised zirconia.

Fig. 10 depicts a typical process chamber used for producing synthetic diamonds. A graphite cylinder 239 surrounds a ceramic cylinder 233. Ceramic caps 231 and 238 close the top and bottom of the process chamber. A second set of ceramic caps 232 and 237 further enclose the interior chamber. For certain processes such as diamond manufacturing, the interior process chamber typically contains a source of graphite 234 and a metal catalyst 235 and a diamond seed 236. Various combinations of catalysts and chamber configurations have been used over the past 20 years and the exact combination of materials will depend on the specific process.

The conical arrangement of the present press will result in a slight temperature gradient within the process chamber, with the diamond seed at the cooler end and the graphite at the hotter end of the process chamber. Such an arrangement may promote conversion of the graphite to diamond.

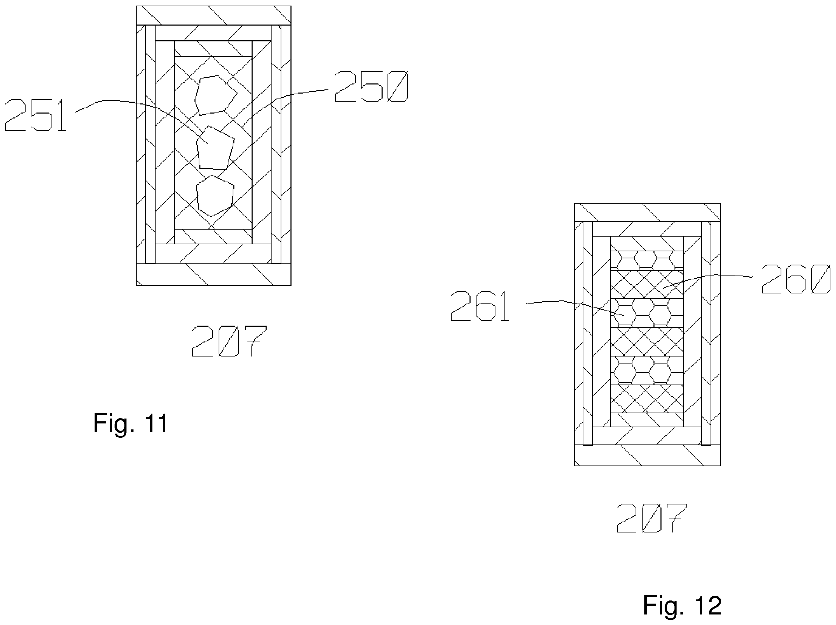

Fig. 11 depicts a typical process chamber 207 used for the clarification and/or colour change of diamonds under HPHT conditions. The clarification of diamonds using HPHT processing is well known in the industry. Diamonds 251 are contained in high purity graphite 250 within the process chamber 207. Under very high temperature, typically > 1500°C, and high pressure conditions certain diamonds can be clarified or the colour can be changed.

Fig. 12 shows an additional HPHT application. Single crystal GaN is used extensively for the manufacture of blue laser diodes. One method to manufacture single crystal GaN is to grow crystalline GaN on a sapphire or silicon wafer. This method results in approximately 10⁶ to 10⁷ defects /sq.cm., resulting in low yields in manufacturing the blue diodes. Single crystal GaN cannot be manufactured using the Czochralski technique of melting amorphous GaN and pulling a single crystal boule as is done with silicon or sapphire. The melting point of GaN is > 2000°C and the GaN will decompose to N₂ and metallic Ga if the GaN is heated at atmospheric pressure. To prevent the GaN from decomposing at high temperatures, the pressure ideally should be > 5GPa (50 kbar). Such conditions can only be obtained in an HPHT apparatus. In Fig. 12 gallium nitride powder 261 is provided in layers separated by graphite powder or discs 260.

### Example 4

Aluminium nitride powder was compressed and heated in a press as shown in Figs. 6-7 of diameter 12 inches and height 11 inches in which the Anvil 214 had a diameter of 0.500 inches [∼12.7mm] and length 0.7 inches [∼17.8mm]. The ceramic cone 211 had a minimum bore diameter of 0.505 inches [∼12.8mm] and was 1.8 inches [∼45.7mm] long. The process used was:-

### Encapsulate AlN:

Large pieces (3-5 mm in diameter) of 5-6 nines purity aluminium nitride are preferred to reduce the risk of oxygen contamination through air or moisture oxidation; however in tests commercially available "high purity" aluminium nitride powder was used. This had 3-5% by weight oxygen impurity.

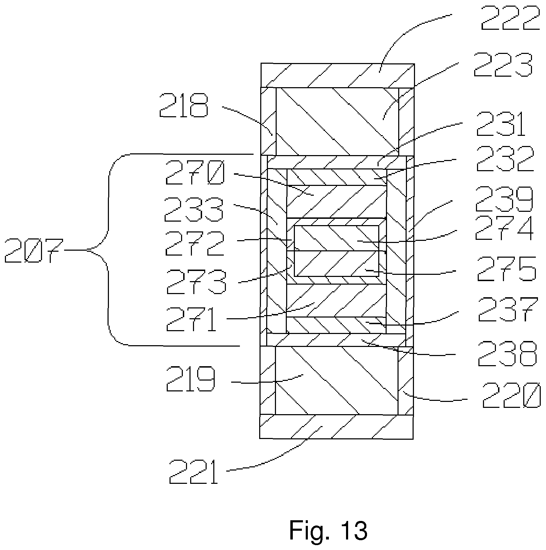

The powder was placed in a foil cup 272, shown in Fig. 13, and compressed to approximately to 30 kpsi [∼207MPa] at room temperature to form an assembly of aluminium nitride 274 in the cup 272. A second assembly of aluminium nitride 275 in a cup 273 was prepared in like manner. The foil cups were made by pressing from tantalum foil, but niobium and other metals resistant to the temperatures required [typically above 2500°C] may substitute.

### Placement of Encapsulated AlN into the HPHT machine:

The assemblies of cup 272 with aluminium nitride 274 and the second cup 273 with aluminium nitride 275 were placed mouth to mouth into a silicon carbide cylinder 233. A graphite disk 270 was placed over the cup 272 and a graphite disk 271 was placed under the cup 273. A disk of zirconia 232 was placed over the graphite disk 270. A disk of zirconia 237 was placed under the graphite disk 271. A zirconia disk 231 was placed over the zirconia disk 232 and a zirconia disk 238 was placed under the zirconia disk 237 closing the ends of the SiC cylinder 233. Zirconia discs 231, 232, 237, and 238 need not be of stabilized zirconia, and indeed materials other than zirconia may be used. These discs serve primarily to transfer pressure to the assemblies of cups 272 and 273 with associated aluminium nitride 274 and 275.

The assembly of cups 272 and 273, aluminium nitride 274 and 275, silicon carbide cylinder 233; and zirconia discs 231, 232, 237, and 238 was placed in a graphite tube 239 to form the process chamber 207. The process chamber 207 together with:-
- An upper zirconia disk 223 surrounded by a graphite tube electrically conductive ring 218;
- a lower zirconia disk 219 surrounded by a graphite tube electrically conductive ring 220;
- an iron electrically conductive disk 222 situated above the zirconia disk 223; and
- a second iron electrically conductive disk 221 situated below the zirconia disk 219;
were placed within a cone 211 as is shown in Fig. 8. The cone 211 was formed of a magnesium stabilised zirconia.

The entire assembly shown in Fig. 13 was then placed into the HPHT machine as is shown in Figs. 6-8.

### Pressing:

The hydraulic piston 302 was raised causing the anvil 214 [which was a tungsten carbide anvil] to compress the process chamber 207 to approximately 460 kpsi [∼3.2GPa]. The iron disks 221 and 222 expand due to the high pressure which seals the process chamber 207 from the atmosphere. The process chamber 207 was then heated to 2500-2800°C, causing the AlN 274 and 275 to melt. The pressure and temperature were held for approximately 30 minutes and the temperature slowly reduced at approximately 10° C per minute.

When temperature was reduced to less than 600°C, the power was turned off and the pressure reduced to zero. The HPHT machine was then opened up. A tantalum capsule with crystallized AlN was removed from the HPHT machine.

It should be noted that the pressures indicated above were calculated from knowing the hydraulic pressure operating on the piston 302 and the mechanical advantage given by the difference in size between the piston and the substantially narrower anvil 214.

Temperatures were estimated by determining an initial calibration curve of power against temperature for the geometry used. This curve extended up to about 1200°C. By exposing various materials to the temperatures involved without application of significant pressure it was possible to extend the calibration curve to higher temperatures. For example, if alumina melted, the temperature in the process cell had to be in the region of the melting point of alumina [∼2000 - 2100°C] and if zirconia melted the temperature in the process cell had to be in the region of the melting point of zirconia [∼2800°C]. Once the calibration curve was obtained temperature could be controlled simply by varying applied power.

Figs. 6-9 above are based on the premise that the cavity in which the process chamber and insulating liner are housed is frusto-conical in form and closed at the end remote from the punch or anvil by a tungsten carbide insert 212. While a frusto-conical form is the simplest shape to meet the requirements as described above, it will be evident that other shapes in which the cavity narrows towards a mouth through which the punch extends are possible. For example the cavity may comprise two or more frusto-conical sections of different conical angle. Further, the cavity may comprise two opposed cavities, and a punch or anvil may extend into a narrow mouth of each cavity.

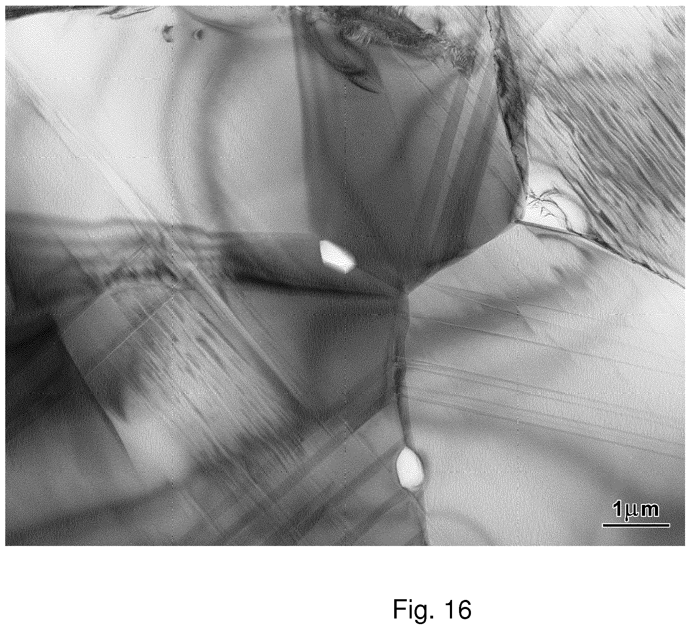

Fig. 16 shows crystallized AlN produced in the HPHT machine using the alleged high purity AlN powder. The crystals are quite small; however the starting AlN powder was subsequently found to have 3-5% oxygen contamination. Purchased AlN powder (advertised as 3 nines) processed in the machine of Figs. 6-7 always had very small crystals, < 1 micron, and the crystals were dark gray to black, indicating significant amounts of impurities, primarily oxygen which was measured using secondary ion mass spectrometry [SIMS] and found to be 3-5% in the AlN power (the manufacturer of the AlN powder does not include the oxygen in the 3 nines).

High purity AlN appears necessary to produce very large AlN crystals and, for the reasons stated above, large pieces (3-5 mm in diameter) of 5-6 nines purity aluminium nitride are preferred.

Fig. 16 does show that the present HTHP machine is capable of melting and re-crystallising AlN and with a suitably high purity source of AlN, large crystals may be obtained. Such a high purity source material can be the product of the PVD apparatus mentioned above.

The control of pressure and temperature in the above examples was controlled manually; however the HPHT system in the following examples is now controlled by a computer resulting in improved pressure and temperature control.

### Example 5

The following example was done using commercially available AlN rod. One of the problems with commercially available AlN powder is the surface area of the powder. The surface area can absorb significant amounts of oxygen. When melting and crystallizing the AlN in the HPHT apparatus of Fig 6-7 significant oxygen contamination may occur. By using AlN rod as the starting material a significant reduction in oxygen contamination was achieved just by the reduced surface area. A reaction volume 207 was made similar to the example above except the encapsulated AlN powder was replaced with AlN rod. The results were small milky white crystals of AlN. Several experiments verified the same results.

### Example 6

The next experiment was to use AlN material made by the PVD apparatus described above and further processed in the HPHT apparatus described above. As an example of such an integrated process, apparatus in accordance with Figs. 1-4 was used in the following process:-
Sputter clean substrate;
   - Place substrate [tantalum or niobium cup] into chamber 101 with shutter 132 closed before or after
   - Clamp substrate 108 to chuck 107
   - Close chamber lid
   - Evacuate chamber 101 to < 2 X 10⁻⁶ Torr (266.6 µPa)
   - Backfill with Ar ∼ 5 sccm
   - Set throttle gate valve 121 to 10-12 mTorr (1.3-1.6 Pa)
   - Turn on substrate plasma generator 106 to 60 watts
   - Etch substrate 108 for 20 min.
   - Turn off substrate plasma generator 106
   - Turn off Ar
   - Open throttle valve 121
AlN deposition:
   - Evacuate chamber 101 to < 2 X 10⁻⁶ Torr
   - Turn on substrate heater to required temperature, 400-1100°C depending on the substrate 108 used
   - Turn on E-beam source (not shown) to 9KV
   - Increase current from 0 to 600 mA
   - Turn on gases
   - Upper chamber 101 NH₃ ∼ 10 sccm
   - Lower chamber 102 Ar 3 sccm
   - Adjust NH₃ flow so upper chamber 101 pressure is ∼ 2 mTorr (266.6 mPa)
   - Lower chamber 102 pressure is ∼ 4-6 x 10⁻⁴ Torr (53.3-80.0 mPa)
   - Adjust E-beam current to achieve desired Al evaporation rate [for example a rate equivalent to an Al deposition rate on the substrate of ∼1.0-1.2 nm/sec].
   - Turn on hollow cathode RF generator 123 to 200-300 watts
   - Turn on substrate RF generator 128 to 15-25 watts
   - Open shutter 132
   - Continue process for required time to achieve desired layer thickness
   - Close shutter 132
Turn off;
   - E-beam
   - Hollow cathode RF generator 123
   - Substrate RF generator 128
   - Substrate heater power
   - all gases and lower Ar (not shown)
Cool chuck 107 to < 300°C
Close gate valve 121
Back fill chambers 101 & 102 with N₂
Open chamber lid (not shown)
Remove substrate clamp (not shown)
Remove substrate 108

The tantalum or niobium cups containing the AlN were then processed in the machine of Figs 6-7. The resulting AlN was observed to have transparent crystals up to 2-5 µm in diameter. The estimated pressing temperature was >2800°C based on observation of melted zirconia on the interior of the cone, even at the high pressure of 500,000 PSI [∼3.45GPa].

AlN from this process was analyzed for impurities. No impurities were found except oxygen, which had levels <5000 ppm as measured by by Glow Discharge Mass Spectrometry, and <300 ppm by SIMS and XRD analysis where these figures represent detection limits for the techniques and suppliers used to make the measurements.

XRD showed the as-deposited AlN from the machine of Figs. 1-4 and the AlN processed in the machine of Figs. 6-7 to have hexagonal crystal structure. Hexagonal AlN is piezo-electric and both the as-deposited and the AlN processed in the HPHT machine proved to be piezo-electric.

Material made by the processes described above may be used as seeds for the processes described above.

Material made by the processes described above may have one or more layers deposited thereon of different composition to said material.

Material made by the processes described above may be used as is, or further processed to form one or more components in a device comprising one or more: electronic components; opto-electronic components; electro-acoustic components; MEMS components; and/or spintronic components.

It should be noted that the above description is for the purpose of exemplification, and the present invention is not limited thereto.

## Claims

1. An ion beam generator comprising:
a) a first chamber (101) housing one or more vapour generators (105) capable of forming a vapour from one or more condensed phase sources of material;
b) a second chamber (102) adjacent the first chamber housing one or more plasma generators (106) comprising one or more cathodes having one or more open-ended channels extending therethrough, the channels comprising one or more channel walls and having a length extending from one end of the channel to another end of the channel to define one or more spaces (110) and capable of forming plasma within said one or more spaces;
c) one or more apertures (104) between the first and second chambers arranged to permit vapour generated in the first chamber to enter the second chamber the one or more vapour generators and one or more plasma generators being arranged whereby in operation, vapour generated by the one or more vapour generators may traverse the one or more spaces through plasma formed by the one or more plasma generators; **characterized in that** the ion beam generator is operable to provide a lower pressure in the first chamber than in the second chamber.

2. An ion beam generator as claimed in Claim 1, wherein the vapour generator is capable of evaporative formation of a vapour from one or more condensed phase sources of material.

3. An ion beam generator as claimed in Claim 2, wherein the vapour generator comprises at least one electron beam generator, operable to direct an electron beam (136) at the one or more condensed phase sources of material.

4. An ion beam generator as claimed in Claim 3, wherein the at least one electron beam generator is operable to magnetically bend electrons from the electron beam generator to the one or more condensed phase sources of material.

5. An ion beam generator as claimed in any one of Claims 1 to 4, wherein the plasma generator further comprises one or more housings spaced from and electrically insulated from the one or more cathodes.

6. An ion beam generator as claimed in any one of Claims 1 to 5, wherein the plasma generator further comprises a source (117) for a magnetic field configured to lie substantially parallel to the one or more channel walls for a substantial fraction of the length of the channel.

7. An ion beam generator as claimed in Claim 6, wherein the source for a magnetic field comprises at least one first magnet situated proximal the vapour generator, and at least one second magnet situated distal the vapour generator.

8. An ion beam generator as claimed in Claim 6 or Claim 7, wherein the source for a magnetic field comprises an electromagnet.

9. An ion beam generator as claimed in any one of Claims 6 to 8, wherein magnetic shielding (103) is disposed between the vapour generator and the plasma generator.

10. Apparatus for manufacturing a material by vapour deposition, the apparatus comprising:-
a) at least one ion beam generator as claimed in any one of Claims 1 to 9;
b) at least one gas supply (112) operable to supply gas for conversion into plasma within the at least one ion beam generator
c) at least one substrate mount (107) to receive at least one substrate, and positioned to permit in use at least one substrate mounted to the at least one substrate mount to be bombarded by ions from the at least one ion beam generator.

11. Apparatus as claimed in Claim 10, further comprising a source (128) operable to apply a bias to a substrate mounted in the substrate mount.

12. Apparatus as claimed in Claim 11, wherein the source is operable to apply a radio frequency to a substrate mounted in the substrate mount.

13. Apparatus as claimed in any one of Claims 10 to 12 in which a heater (125, 126, 127) is provided to heat the substrate mount.

14. Apparatus as claimed in any one of Claims 10 to 13 comprising one or more vents situated between the plasma chamber and the substrate mount, and operable to admit gas close to the substrate mount.

15. Apparatus as claimed in any one of Claims 10 to 14, wherein the vapour generator is capable of evaporative formation of a vapour from one or more condensed phase sources of material, and comprising a source operable to inject gas in the region of the vapour generator to inhibit reaction between reactant gases and at least a surface of the condensed phase sources of material.

16. Apparatus as claimed in any one of Claims 10 to 15, comprising a shutter selectively operable to inhibit transfer of vapour from the first chamber to the second chamber.

17. Apparatus as claimed in any one of Claims 10 to 16, wherein one or more crucibles (135) are provided to house said one or more condensed phase sources of material.

18. A method of manufacturing a composition or an article comprising a composition, the method comprising the step of, in an apparatus as claimed in any one of Claims 10 to 17, forming an ion beam from the at least one ion beam generator and bombarding at least one substrate with ions from the ion beam to form a deposit on the substrate.

19. A method as claimed in Claim 18 in which the deposit on the substrate forms an adherent coating to the substrate.

20. A method as claimed in Claim 19 in which the substrate is a coated substrate having a surface coating, and the deposit forms on the surface coating.

21. A method as claimed in Claim 19 or 20, in which the substrate is a crucible body and the deposit on the substrate forms an adherent coating in contact with at least an inner surface of the crucible body.

22. A method as claimed in any of Claims 19 to 20, in which the deposit is chemically attached to said substrate.

23. A method as claimed in Claim 22, in which the surface coating comprises diamond or diamond-like carbon.

24. A method as claimed in any of Claims 18 to 23, in which a surface of the substrate is polished prior to forming the deposit on the surface.

25. A method as claimed in any of Claims 18 to 24, wherein additional bombardment of the substrate comes from ions produced in the vicinity of the substrate.

26. A method as claimed in any of Claims 18 to 25, wherein the composition comprises at least a first component and at least a second component, and the ion beam comprises at least the first component.

27. A method as claimed in Claim 26, wherein the ion beam further comprises further components of the composition.

28. A method as claimed in any one of Claims 18 to 27, wherein the composition is deposited at a rate in excess of 40µm/hour.

29. A method as claimed in any one of Claims 18 to 28, wherein the deposited composition is deposited to a thickness in excess of 1mm.

30. A method as claimed in any one of Claims 18 to 29, wherein the deposited composition is separated from the substrate to form a freestanding body.

31. A method as claimed in any one of Claims 18 to 30, wherein the deposited composition is divided to form wafers.

32. A method as claimed in any one of Claims 18 to 30 wherein the deposited composition is divided to form substrates.

33. A method as claimed in Claim 32, wherein the substrates are for use in the method of Claim 18.

34. A method as claimed in any one of Claims 18 to 32 wherein the deposited composition is used as is, or further processed, to form one or more components in a device comprising one or more of: electronic components; opto-electronic components; electro-acoustic components; MEMS components; and/or spintronic components.

35. A method as claimed in Claim 34, wherein said component is a heat conductor or heat spreader.

36. A method as claimed in any one of Claims 18 to 34, wherein the composition is an (Al,Ga,In)N composition.

37. A method as claimed in Claim 36, in which the composition is crystalline hexagonal AlN.

38. A method as claimed in Claim 37 in which the substrate is, or is coated with, a metal, glass, ceramic, diamond, or diamond-like carbon.

## Patentansprüche

1. Ionenstrahlgenerator, umfassend:
a) eine erste Kammer (101), in der ein oder mehr Dampfgeneratoren (105) aufgenommen sind, die in der Lage sind, einen Dampf aus einer oder mehr Quellen von Material in kondensierter Phase zu bilden,
b) eine zweite Kammer (102) neben der ersten Kammer, in der ein oder mehr Plasmagenerator(en) (106) aufgenommen sind, die eine oder mehr Kathode(n) aufweisen mit einem oder mehr offenendigen Kanälen, die sich durch diese hindurch erstrecken, wobei die Kanäle eine oder mehr Kanalwände aufweisen und eine Länge besitzen, die sich von einem Ende des Kanals zu einem anderen Ende des Kanals erstreckt, um einen oder mehr Räume (110) zu definieren, und in der Lage sind, Plasma innerhalb dieses einen Raums oder mehrerer Räume zu bilden,
c) eine oder mehr Öffnungen (104) zwischen der ersten und zweiten Kammer, die angeordnet sind, damit in der ersten Kammer erzeugter Dampf in die zweite Kammer eintreten kann, wobei der eine oder mehr Dampfgenerator(en) und der eine oder mehr Plasmagenerator(en) angeordnet sind, wodurch beim Betrieb Dampf, der durch den einen oder mehr Dampfgeneratoren erzeugt wird, durch den einen oder mehr Räume durch Plasma treten kann, das durch den einen oder mehr Plasmagenerator(en) gebildet wird,
**dadurch gekennzeichnet, dass**
der Ionenstrahlgenerator betrieben werden kann, um in der ersten Kammer einen niedrigeren Druck bereitzustellen als in der zweiten Kammer.

2. Ionenstrahlgenerator nach Anspruch 1, wobei der Dampfgenerator in der Lage ist, durch Verdampfung einen Dampf aus einer oder mehr Quellen von Material in kondensierter Phase zu bilden.

3. Ionenstrahlgenerator nach Anspruch 2, wobei der Dampfgenerator zumindest einen Elektronenstrahlgenerator aufweist, der betrieben werden kann, um einen Elektronenstrahl (136) auf die eine oder mehr Quellen von Material in kondensierter Phase zu richten.

4. Ionenstrahlgenerator nach Anspruch 3, wobei der zumindest eine Elektronenstrahlgenerator betrieben werden kann, um Elektronen aus dem Elektronenstrahlgenerator zu der einen oder mehr Quellen von Material in kondensierter Phase zu biegen.

5. Ionenstrahlgenerator nach einem der Ansprüche 1 bis 4, wobei der Plasmagenerator ferner ein oder mehr Gehäuse aufweist, die voneinander beabstandet und elektrisch von der einen oder mehr Kathode(n) isoliert sind.

6. Ionenstrahlgenerator nach einem der Ansprüche 1 bis 5, wobei der Plasmagenerator ferner eine Quelle (117) für ein Magnetfeld aufweist, das eingerichtet ist, um für einen wesentlichen Anteil der Länge des Kanals im Wesentlichen parallel zu der einen oder mehr Kanalwände zu liegen.

7. Ionenstrahlgenerator nach Anspruch 6, wobei die Quelle für ein Magnetfeld zumindest einen ersten Magneten, der proximal zu dem Dampfgenerator gelegen ist, und zumindest einen zweiten Magneten aufweist, der distal zu dem Dampfgenerator gelegen ist.

8. Ionenstrahlgenerator nach Anspruch 6 oder Anspruch 7, wobei die Quelle für ein Magnetfeld einen Elektromagneten umfasst.

9. Ionenstrahlgenerator nach einem der Ansprüche 6 bis 8, wobei eine Magnetabschirmung (103) zwischen dem Dampfgenerator und dem Plasmagenerator angeordnet ist.

10. Vorrichtung zur Herstellung eines Materials durch Dampfabscheidung, umfassend:
a) zumindest einen Ionenstrahlgenerator nach einem der Ansprüche 1 bis 9;
b) zumindest eine Gaszufuhr (112), die betrieben werden kann, um Gas zur Umwandlung in Plasma innerhalb des zumindest einen Ionenstrahlgenerators zuzuführen;
c) zumindest eine Substrathalterung (107) zur Aufnahme von zumindest einem Substrat,
welche positioniert ist, um es im Betrieb zumindest einem an der zumindest einen Substrathalterung befestigten Substrat zu ermöglichen, durch Ionen von dem zumindest einen Ionenstrahlgenerator beschossen zu werden.

11. Vorrichtung nach Anspruch 10, ferner aufweisend eine Quelle (128), die betrieben werden kann, um eine Vormagnetisierung auf ein in der Substrathalterung befestigtes Substrat aufzubringen.

12. Vorrichtung nach Anspruch 11, wobei die Quelle betrieben werden kann, um eine Funkfrequenz auf ein in der Substrathalterung befestigtes Substrat aufzubringen.

13. Vorrichtung nach einem der Ansprüche 10 bis 12, bei der ein Erhitzer (125, 126, 127) zum Erwärmen der Substrathalterung bereitgestellt ist.

14. Vorrichtung nach einem der Ansprüche 10 bis 13, umfassend eine oder mehr Lüftungsöffnungen zwischen der Plasmakammer und der Substrathalterung, und welche betrieben werden können, um Gas nahe an der Substrathalterung einzulassen.

15. Vorrichtung nach einem der Ansprüche 10 bis 14, wobei der Dampfgenerator in der Lage ist, durch Verdampfung einen Dampf aus einer oder mehr Quellen von Material in kondensierter Phase zu bilden, und umfassend eine Quelle, die betrieben werden kann, um Gas in den Bereich des Dampfgenerators einzudüsen, um eine Reaktion zwischen Reaktionsgasen und zumindest einer Oberfläche der Quellen von Material in kondensierter Phase zu verhindern.

16. Vorrichtung nach einem der Ansprüche 10 bis 15, umfassend eine Klappe, die wahlweise betrieben werden kann, um den Übergang von Dampf von der ersten Kammer zu der zweiten Kammer zu verhindern.

17. Vorrichtung nach einem der Ansprüche 10 bis 16, wobei ein oder mehr Tiegel (135) vorhanden sind, um die eine oder mehr Quellen von Material in kondensierter Phase aufzunehmen.

18. Verfahren zur Herstellung einer Zusammensetzung oder eines Artikels, umfassend eine Zusammensetzung, das Verfahren umfassend, in einer Vorrichtung nach einem der Ansprüche 10 bis 17, die Schritte des Bildens eines Ionenstrahls von dem zumindest einen Ionenstrahlgenerator und Beschießens von zumindest einem Substrat mit Ionen aus dem Ionenstrahl, um eine Ablagerung auf dem Substrat zu bilden.

19. Verfahren nach Anspruch 18, bei dem die Ablagerung auf dem Substrat eine anhaftende Beschichtung auf dem Substrat bildet.

20. Verfahren nach Anspruch 19, bei dem das Substrat ein beschichtetes Substrat mit einer Oberflächenbeschichtung ist und die Ablagerung sich auf der Oberflächenbeschichtung bildet.

21. Verfahren nach Anspruch 19 oder 20, bei dem das Substrat ein Tiegelkörper ist und die Ablagerung auf dem Substrat eine anhaftende Beschichtung bildet, die zumindest mit einer Innenfläche des Tiegelkörpers in Kontakt ist.

22. Verfahren nach einem der Ansprüche 19 bis 20, bei dem die Ablagerung mit dem Substrat chemisch verbunden ist.

23. Verfahren nach Anspruch 22, bei dem die Oberflächenbeschichtung Diamant- oder diamantartigen Kohlenstoff umfasst.

24. Verfahren nach einem der Ansprüche 18 bis 23, bei dem eine Oberfläche des Substrats vor der Bildung der Ablagerung auf der Oberfläche poliert wird.

25. Verfahren nach einem der Ansprüche 18 bis 24, wobei ein zusätzlicher Beschuss des Substrats von Ionen kommt, die in der Nähe des Substrats erzeugt wurden.

26. Verfahren nach einem der Ansprüche 18 bis 25, wobei die Zusammensetzung zumindest einen ersten Bestandteil und einen zumindest einen zweiten Bestandteil umfasst und der Ionenstrahl zumindest den ersten Bestandteil umfasst.

27. Verfahren nach Anspruch 26, wobei der Ionenstrahl ferner weitere Bestandteile der Zusammensetzung umfasst.

28. Verfahren nach einem der Ansprüche 18 bis 27, wobei die Zusammensetzung bei einer Rate von mehr als 40 µm/Stunde abgelagert wird.

29. Verfahren nach einem der Ansprüche 18 bis 28, wobei die abgelagerte Zusammensetzung auf eine Dicke von mehr als 1 mm abgelagert wird.

30. Verfahren nach einem der Ansprüche 18 bis 29, wobei die abgelagerte Zusammensetzung von dem Substrat getrennt wird, um einen freistehenden Körper zu bilden.

31. Verfahren nach einem der Ansprüche 18 bis 30, wobei die abgelagerte Zusammensetzung geteilt wird, um Wafer zu bilden.

32. Verfahren nach einem der Ansprüche 18 bis 30, wobei die abgelagerte Zusammensetzung geteilt wird, um Substrate zu bilden.

33. Verfahren nach Anspruch 32, wobei die Substrate zur Verwendung in dem Verfahren nach Anspruch 18 vorgesehen sind.

34. Verfahren nach einem der Ansprüche 18 bis 32, wobei die abgelagerte Zusammensetzung wie vorliegend verwendet wird oder weiterverarbeitet wird, um einen oder mehr Bestandteile in einer Vorrichtung zu bilden, die einen oder mehr von den folgenden Bauteilen umfasst: elektronische Bauteile, optoelektronische Bauteile; elektroakustische Bauteile; MEMS-Bauteile und/oder spintronische Bauteile.

35. Verfahren nach Anspruch 34, wobei der Bauteil ein Wärmeleiter oder Wärmeverteiler ist.

36. Verfahren nach einem der Ansprüche 18 bis 34, wobei die Zusammensetzung eine (Al,Ga,In)N-Zusammensetzung ist.

37. Verfahren nach Anspruch 36, bei dem die Zusammensetzung kristallines, hexagonales AIN ist.

38. Verfahren nach Anspruch 37, bei dem das Substrat ein Metall, Glas, Keramik, Diamant oder diamantartiger Kohlenstoff ist oder damit beschichtet ist.

## Revendications

1. Générateur de faisceau ionique comprenant :
a) une première chambre (101) abritant un ou plusieurs générateurs de vapeur (105) capable de former une vapeur à partir d'une ou plusieurs sources à phase condensée de matériau ;
b) une deuxième chambre (102) adjacente à la première chambre abritant un ou plusieurs générateurs de plasma (106) comprenant
une ou plusieurs cathodes ayant un ou plusieurs canaux à extrémité ouverte s'étendant au travers de celles-ci, les canaux comprenant une ou plusieurs parois de canal et ayant une longueur s'étendant d'une extrémité du canal à une autre extrémité du canal pour définir un ou plusieurs espaces (110) et capables de former un plasma dans lesdits un ou plusieurs espaces ;
c) une ou plusieurs ouvertures (104) entre les première et deuxième chambres agencées pour permettre à une vapeur générée dans la première chambre d'entrer dans la deuxième chambre, les uns ou plusieurs générateurs de vapeur et un ou plusieurs générateurs de plasma étant agencés pour que, en fonctionnement, la vapeur générée par l'un ou plusieurs générateurs de vapeur puisse traverser les uns ou plusieurs espaces dans le plasma formé par les uns ou plusieurs générateurs de plasma ;
**caractérisé en ce que**
le générateur de faisceau ionique peut fonctionner de façon à fournir une pression plus faible dans la première chambre que dans la deuxième chambre.

2. Générateur de faisceau ionique selon la revendication 1, dans lequel le générateur de vapeur est capable de former par évaporation une vapeur à partir d'une ou plusieurs sources à phase condensée de matériau.

3. Générateur de faisceau ionique selon la revendication 2, dans lequel le générateur de vapeur comprend au moins un générateur de faisceau d'électrons, pouvant fonctionner de façon à diriger un faisceau d'électrons (136) sur les une ou plusieurs sources à phase condensée de matériau.

4. Générateur de faisceau ionique selon la revendication 3, dans lequel l'au moins un générateur de faisceau d'électrons peut fonctionner de façon à orienter magnétiquement les électrons du générateur de faisceaux d'électrons vers l'une ou plusieurs sources à phase condensée de matériau.

5. Générateur de faisceau ionique selon l'une quelconque des revendications 1 à 4, dans lequel le générateur de plasma comprend en outre un ou plusieurs logements espacés et isolés électriquement des une ou plusieurs cathodes.

6. Générateur de faisceau ionique selon l'une quelconque des revendications 1 à 5, dans lequel le générateur de plasma comprend en outre une source (117) pour un champ magnétique configuré pour être substantiellement parallèle aux une ou plusieurs parois de canal pour une fraction substantielle de la longueur du canal.

7. Générateur de faisceau ionique selon la revendication 6, dans lequel la source d'un champ magnétique comprend au moins un premier aimant situé sur le plan proximal du générateur de vapeur, et au moins un deuxième aimant situé sur le plan distal du générateur de vapeur.

8. Générateur de faisceau ionique selon la revendication 6 ou la revendication 7, dans lequel la source pour un champ magnétique comprend un électro-aimant.

9. Générateur de faisceau ionique selon l'une quelconque des revendications 6 à 8, dans lequel un écran magnétique (103) est disposé entre le générateur de vapeur et le générateur de plasma.

10. Appareil pour la fabrication d'un matériau par dépôt de vapeur, l'appareil comprenant :
a) au moins un générateur de faisceau ionique selon l'une quelconque des revendications 1 à 9 ;
b) au moins une alimentation en gaz (112) pouvant fonctionner de façon à fournir du gaz pour une conversion en plasma dans l'au moins un générateur de faisceau ionique
c) au moins un support de substrat (107) pour recevoir au moins un substrat, et positionné pour permettre lors de l'utilisation, de bombarder au moins un substrat monté sur l'au moins un support de substrat par des ions de l'au moins un générateur de faisceau ionique.

11. Appareil selon la revendication 10, comprenant en outre une source (128) pouvant fonctionner de façon à appliquer une polarisation sur un substrat monté dans le support de substrat.

12. Appareil selon la revendication 11, dans lequel la source peut fonctionner de façon à appliquer une fréquence radio à un substrat monté dans le support de substrat.

13. Appareil selon l'une quelconque des revendications 10 à 12 dans lequel un système de chauffage (125, 126, 127) est fourni pour chauffer le support de substrat.

14. Appareil selon l'une quelconque des revendications 10 à 13 comprenant un ou plusieurs évents situés entre la chambre de plasma et le support de substrat, et pouvant fonctionner de façon à recevoir un gaz à proximité du support de substrat.

15. Appareil selon l'une quelconque des revendications 10 à 14, dans lequel le générateur de vapeur est capable de former par évaporation une vapeur d'une ou plusieurs sources à phase condensée de matériau, et comprenant une source pouvant fonctionner pour injecter du gaz dans la région du générateur de vapeur pour inhiber une réaction entre des gaz réactifs et au moins une surface des sources à phase condensée de matériau.

16. Appareil selon l'une quelconque des revendications 10 à 15, comprenant un volet pouvant fonctionner sélectivement de façon à inhiber le transfert de vapeur de la première chambre à la deuxième chambre.

17. Appareil selon l'une quelconque des revendications 10 à 16, dans lequel un ou plusieurs creusets (135) sont fournis pour abriter lesdites une ou plusieurs sources à phase condensée de matériau.

18. Procédé de fabrication d'une composition ou d'un article comprenant une composition, le procédé comprenant l'étape consistant à former, dans un appareil selon l'une quelconque des revendications 10 à 17, un faisceau ionique de l'au moins un générateur de faisceau ionique et à bombarder au moins un substrat avec des ions du faisceau ionique pour former un dépôt sur le substrat.

19. Procédé selon la revendication 18, dans lequel le dépôt sur le substrat forme un revêtement adhésif sur le substrat.

20. Procédé selon la revendication 19, dans lequel le substrat est un substrat appliqué ayant un revêtement de surface et le dépôt se forme sur le revêtement de surface.

21. Procédé selon la revendication 19 ou 20, dans lequel le substrat est un corps de creuset et le dépôt sur le substrat forme un revêtement adhésif en contact avec au moins une surface interne du corps de creuset.

22. Procédé selon l'une quelconque des revendications 19 à 20, dans lequel le dépôt est fixé chimiquement audit substrat.

23. Procédé selon la revendication 22, dans lequel le revêtement de surface comprend un diamant ou un carbone adamantin.

24. Procédé selon l'une quelconque des revendications 18 à 23, dans lequel une surface du substrat est polie avant de former le dépôt sur la surface.

25. Procédé selon l'une quelconque des revendications 18 à 24, dans lequel un bombardement supplémentaire du substrat provient des ions produits à proximité du substrat.

26. Procédé selon l'une quelconque des revendications 18 à 25, dans lequel la composition comprend au moins un premier composant et au moins un deuxième composant, et le faisceau ionique comprend au moins un premier composant.

27. Procédé selon la revendication 26, dans lequel le faisceau ionique comprend en outre d'autres composants de la composition.

28. Procédé selon l'une quelconque des revendications 18 à 27, dans lequel la composition est déposée à une vitesse dépassant 40 µm/ heure.

29. Procédé selon l'une quelconque des revendications 18 à 28, dans lequel la composition déposée est déposée en une épaisseur dépassant 1 mm.

30. Procédé selon l'une quelconque des revendications 18 à 29, dans lequel la composition déposée est séparée du substrat pour former un corps indépendant.

31. Procédé selon l'une quelconque des revendications 18 à 30, dans lequel la composition déposée est divisée pour former des galettes.

32. Procédé selon l'une quelconque des revendications 18 à 30, dans lequel la composition déposée est divisée pour former des substrats.

33. Procédé selon la revendication 32, dans lequel les substrats sont destinés à être utilisés dans le procédé de la revendication 18.

34. Procédé selon l'une quelconque des revendications 18 à 32, dans lequel la composition déposée est utilisée telle quelle ou est encore traitée pour former un ou plusieurs composants en un dispositif comprenant l'un ou plusieurs parmi : des composants électroniques ; des composants opto-électroniques ; des composants électro-acoustiques ; des composants MEMS ; et/ou des composants spintroniques.

35. Procédé selon la revendication 34, dans lequel ledit composant est un conducteur de chaleur ou diffuseur de chaleur.

36. Procédé selon l'une quelconque des revendications 18 à 34, dans lequel la composition est une composition de (Al, Ga, In)N.

37. Procédé selon la revendication 36, dans lequel la composition est un AIN cristallin hexagonal.

38. Procédé selon la revendication 37, dans lequel le substrat est en, ou est revêtu de métal, de verre, de céramique, de diamant ou de carbone adamantin.
